# EUROPEAN PATENT SPECIFICATION

(11) **EP 4 138 533 B1**
(45) Date of publication and mention of the grant of the patent: **30.07.2025**
(21) Application number: 21787685.3
(22) Date of filing: 12.03.2021
(51) Int. Cl.: H05K 9/00, H05K 1/14, H05K 1/11, H05K 3/36, H04B 1/38, H04M 1/02

(54) **ELECTRONIC DEVICE INCLUDING SHIELD CAN**
ELEKTRONISCHE VORRICHTUNG MIT ABSCHIRMDOSE
DISPOSITIF ÉLECTRONIQUE COMPRENANT UN BOÎTIER DE BLINDAGE

(30) Priority: 17.04.2020 KR 20200046872
(43) Date of publication of application: 22.02.2023
(73) Proprietor: Samsung Electronics Co., Ltd., Gyeonggi-do 16677 (KR)
(72) Inventor: PARK, Taewoong, Suwon-si Gyeonggi-do 16677 (KR); PARK, Changkyu, Suwon-si Gyeonggi-do 16677 (KR); KANG, Hanvit, Suwon-si Gyeonggi-do 16677 (KR); KIM, Beomju, Suwon-si Gyeonggi-do 16677 (KR); SEO, Soohyun, Suwon-si Gyeonggi-do 16677 (KR); HUH, Jaeyoung, Suwon-si Gyeonggi-do 16677 (KR); HONG, Hyunchul, Suwon-si Gyeonggi-do 16677 (KR)
(74) Representative: Arnold & Siedsma
(86) International application number: PCT/KR2021/003083
(87) International publication number: WO 2021/210788

(56) References cited:
- WO-A1-2008/059643
- KR-A- 20130 008 924
- KR-A- 20200 032 911
- US-A- 5 352 925
- US-A- 6 118 347
- US-A1- 2008 291 654
- US-A1- 2010 085 719
- US-A1- 2013 153 286
- US-A1- 2013 201 648

## Description

### [Technical Field]

Various embodiments of the disclosure relate to an electronic device including a shield can.

### [Background Art]

With the development of information and communication technology and semiconductor technology, the distribution and use of electronic devices are rapidly increasing. These electronic devices tend to converge and provide various functions, rather than staying in their own domains. US 2008/291654 A1 discloses a wireless communication module assembly comprising: a main board having a top surface on which a plurality of grounding pads are provided; a circuit board unit having a bottom surface electrically mounted on the top surface of the main board, a top surface with a plurality of grounding pads, and a plurality of notches corresponding to the grounding pads of the main board; and a metal cap covering the circuit board unit and having first mounting legs respectively and electrically connected with the grounding pads of the circuit board unit, and second mounting legs respectively passing through the notches of the circuit board unit and electrically connected with the grounding pads of the main board. US 2010/085719 A1 discloses a chip package structure with a shielding cover, comprising: a substrate; a chip, disposed on and electrically connected to the substrate; a pair of first passive components, disposed on the substrate; a pair of second passive components, disposed on the substrate; and a shielding cover, disposed on the substrate and covering the chip, the shielding cover having a plurality of leads connected to the substrate, the leads including a first lead and a second lead, wherein the first lead connected to a portion of the substrate is located between the pair of first passive components and arranged along a first axis with the pair of first passive components, and the second lead connected to a portion of the substrate is located between the pair of second passive components and arranged along a second axis with the pair of second passive components. US 6 118 347 A discloses an electronic apparatus comprising: a main board having a main-circuit mounting region and an oscillating-circuit mounting region; a shielding case for covering said oscillating-circuit mounting region by being attached to said main board, said shielding case having a pair of cutout portions formed in opposing sidewalls thereof; a sub-board on which circuit components including an oscillating circuit portion are mounted, said sub-board having a pair of projecting portions corresponding to the cutout portions, whereby said sub-board is supported at a position spaced apart from said main board inside said shielding case by fitting the projecting portions into the cutout portions; and a connector for electrically connecting said sub-board and said main board. US 2013/153286 A1 discloses a shielding system for a mobile device, the system comprising: a Printed Circuit Board (PCB) with a first area and a thickness; and a shield enclosure, spaced apart and above a front side of the PCB at a certain distance, for enclosing components on the PCB, wherein parts of the shield enclosure are coupled to at least one of a lateral side and a back side of the PCB.

While the thicknesses of electronic devices are gradually getting thinner to improve user convenience and aesthetics of the electronic devices, the number of electronic components that are to be disposed in the internal spaces of the electronic devices to perform various functions of the electronic devices is gradually increasing. Accordingly, various methods for efficiently utilizing the internal spaces of electronic devices have been proposed.

### [Disclosure of Invention]

### [Technical Problem]

As a method for securing a mounting space for various electronic components of an electronic device in a limited internal space of the electronic device, a structure in which a plurality of printed circuit boards are stacked by using an interposer has been proposed. As an example, a mounting space for electronic components may be secured in an electronic device by disposing a second printed circuit board on a first printed circuit board, and electrically connecting the first printed circuit board and the second printed circuit board by using an interposer.

A structure in which a plurality of printed circuit boards are stacked by using an interposer may make it possible to secure a mounting space for electronic components, but may be vulnerable to damage or fracture due to an external force. Thus, a method of increasing physical connection strength of the plurality of printed circuit boards and/or the interposer is required.

As a method of increasing physical connection strength of the plurality of printed circuit boards and/or the interposer, there has been proposed a method of soldering the plurality of printed circuit boards and the interposer to each other. However, in the method of soldering the printed circuit boards and the interposer, since the solder regions are relatively weak in rigidity compared to other components (e.g., a plurality of printed circuit boards or an interposer), the solder regions may be fractured (or "cracked") prior to the plurality of printed circuit boards and /or the interposer.

As another method of increasing the physical connection strength of a plurality of printed circuit boards and/or an interposer, there has been proposed a method of reinforcing the physical connection strength by disposing support structures on the plurality of printed circuit boards or applying a resin between the plurality of printed circuit boards and the interposer.

However, in the method of disposing support structures on the plurality of printed circuit boards, it is essential to secure a mounting space for disposing the support structures on the printed circuit boards, and the plurality of printed circuit boards and/or the interposer may be damaged due to the support structures. In addition, in the method of applying a resin between the plurality of printed circuit boards and the interposer, defects may occur in the plurality of printed circuit boards and/or the interposer in the process of applying the resin.

That is, in the case of the above-described methods, sufficient connection strength between the plurality of printed circuit boards and the interposer may not be secured, or defects may be caused in the plurality of printed circuit boards and/or the interposer. Therefore, there is a need for a new method for increasing the connection strength between the plurality of printed circuit boards and the interposer without causing defects in the printed circuit boards and the interposer.

Accordingly, various embodiments of the disclosure provide an electronic device in which physical connection strength between a plurality of printed circuit boards and an interposer is capable of being reinforced by expanding a partial region of a shield can provided on the printed circuit boards.

### [Solution to Problem]

An electronic device according to an embodiment of the disclosure is defined by independent claim 1.

Further embodiments are described by the dependent claims.

### [Advantageous Effects of Invention]

In an electronic device according to an embodiment of the disclosure, it is possible to increase a physical connection strength of a printed circuit board stack structure including a first printed circuit board, an interposer, and a second printed circuit board.

In an electronic device according to an embodiment of the disclosure, it is possible to reduce damage to the first print circuit and/or the second printed circuit board by an external force by dispersing an impact applied to the first printed circuit board and/or the second printed circuit board to a shield structure (e.g., a shield can).

### [Brief Description of Drawings]

FIG. 1 is a block diagram of an electronic device according to various embodiments in a network environment.
FIG. 2A is a perspective view illustrating the front side of an electronic device according to an embodiment.
FIG. 2B is a perspective view illustrating the rear side of the electronic device of FIG. 2A.
FIG. 3 is an exploded perspective view illustrating an electronic device according to an embodiment.
FIG. 4 is a view illustrating a side member of an electronic device and a printed circuit board structure disposed on the side member according to an embodiment.
FIG. 5 is an exploded view illustrating a printed circuit board structure and a shield structure of an electronic device according to an embodiment
FIG. 6 is an exploded view illustrating a printed circuit board structure and a shield structure of an electronic device according to another embodiment.
FIG. 7 is a front view illustrating a printed circuit board structure of an electronic device according to an embodiment.
FIG. 8 is a cross-sectional perspective view illustrating the printed circuit board structure of FIG. 7 cut in A-A' direction.
FIG. 9 is a side view illustrating the printed circuit board structure of FIG. 8.
FIG. 10A is a front view illustrating a printed circuit board structure of an electronic device according to another embodiment.
FIG. 10B is a front view illustrating a printed circuit board structure of an electronic device according to still another embodiment not covered by the invention.
FIG. 11A is a cross-sectional view illustrating a printed circuit board structure according to an embodiment cut-in B-B' direction of FIG. 10A.
FIG. 11B is a cross-sectional view illustrating a printed circuit board structure according to another embodiment cut in B-B' direction of FIG. 10A.
FIG. 11C is a cross-sectional view illustrating a printed circuit board structure according to still another embodiment cut in B-B' direction of FIG. 10A.
FIG. 12 is a front view illustrating a printed circuit board structure and a support structure of an electronic device according to an embodiment.
FIG. 13 is a cross-sectional perspective view illustrating the printed circuit board structure and the support structure of FIG. 12 cut in C-C' direction.
FIG. 14 is a side view illustrating the printed circuit board structure and the supporting structure of FIG. 13.

### [Mode for Carrying out the Invention]

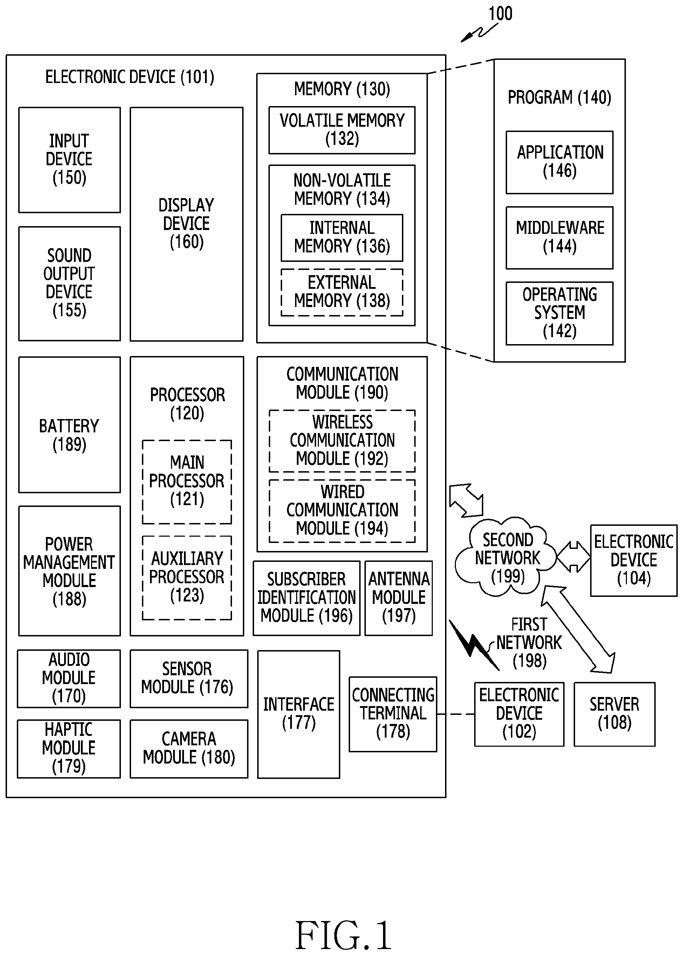

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module(SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140may be stored in the memory 130 as software, and may include, for example, an operating system (OS) 142, middleware 144, or an application 146.

The input device 150 may receive a command or data to be used by other component (e.g., the processor 120) of the electronic device 101, from the outside (e.g., a user) of the electronic device 101. The input device 150 may include, for example, a microphone, a mouse, a keyboard, or a digital pen (e.g., a stylus pen).

The sound output device 155 may output sound signals to the outside of the electronic device 101. The sound output device 155 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 150, or output the sound via the sound output device 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., PCB). According to an embodiment, the antenna module 197 may include a plurality of antennas. In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101) . For example, a processor(e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

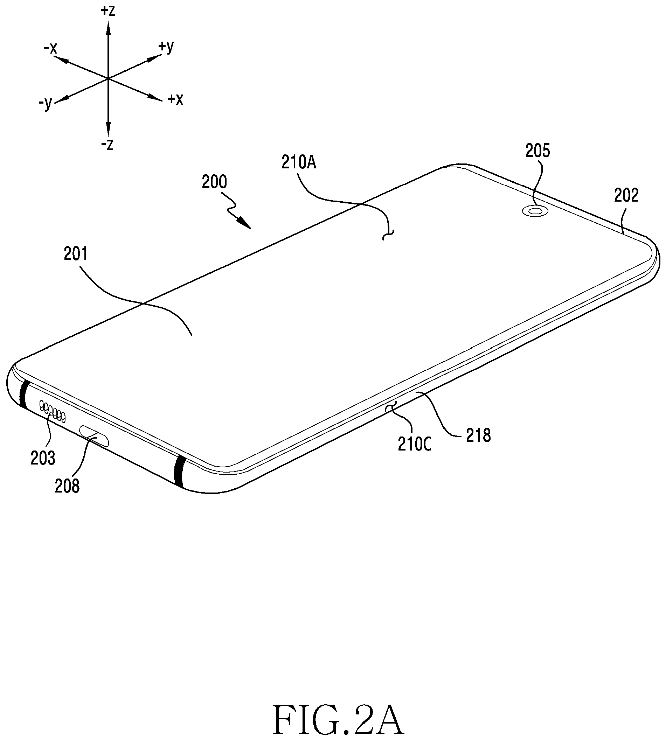

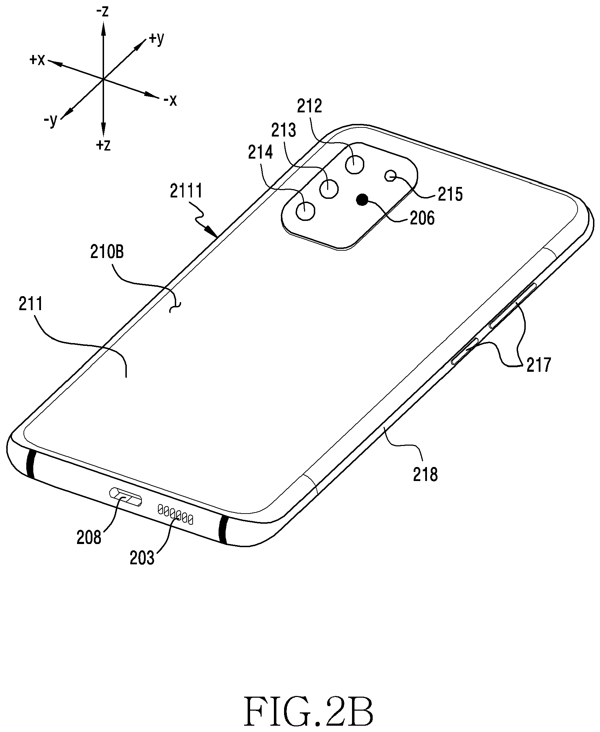

FIG. 2A is a perspective view illustrating the front side of an electronic device according to an embodiment, and FIG. 2B is a perspective view illustrating the rear side of the electronic device of FIG. 2A.

Referring to FIGS. 2A and 2B, an electronic device 200 (e.g., the electronic device 101 in FIG. 1) according to an embodiment may include a housing 210 including a first surface (or a "front surface") 210A, a second surface (or a "rear surface") 210B, and a side surface (a "side wall") 210C surrounding a space between the first surface 210A and the second surface 210B. In another embodiment (not illustrated), the term "housing 210" may refer to a structure defining a part of the first surface 210A, the second surface 210B, and the side surface 210C of FIGS. 2A and 2B.

According to an embodiment, at least a portion of the first surface 210A may be defined by a substantially transparent front plate 202 (e.g., a glass plate or a polymer plate including various coating layers). According to an embodiment, the front plate 202 may include a curved portion bent and seamlessly extending from the first surface 210A toward the rear plate 211 in at least one side edge portion.

According to an embodiment, the second surface 210B may be defined by a substantially opaque rear plate 211. The rear plate 211 may be made of, for example, coated or colored glass, ceramic, polymer, or metal (e.g., aluminum, stainless steel (STS), or magnesium), or a combination of two or more of these materials. According to an embodiment, the rear plate 211 may include a curved portion bent and extending seamlessly from the second surface 210B towards the front plate 202 in at least one side edge portion.

According to an embodiment, the side surface 210C may be defined by a side member (or a "bracket") 218 coupled to the front plate 202 and the rear plate 211 and including a metal and/or a polymer. In some embodiments, the rear plate 211 and the side member 218 may be configured in an integral structure, and may include the same material (e.g., a metal material such as aluminum).

According to an embodiment, the electronic device 200 may include at least one of a display 201, an audio module 203, a sensor module (not illustrated), camera modules 205, 212, 213, and 206, a key input device 217, and a connector hole 208. In some embodiments, in the electronic device 200, at least one of the components (e.g., the key input devices 217) may be omitted, or other components may be additionally included. For example, the electronic device 200 may include a sensor module (not illustrated). For example, in a region provided by the front plate 202, a sensor, such as a proximity sensor or an illuminance sensor, may be integrated into the display 201 or disposed at a position adjacent to the display 201. In some embodiments, the electronic device 200 may further include a light-emitting element, and the light-emitting element may be disposed at a position adjacent to the display 201 in the region provided by the front plate 202. The light-emitting element may provide, for example, the state information of the electronic device 200 in an optical form. In another embodiment, the light-emitting element may provide, for example, a light source that is interlocked with the operation of the camera module 205. The light-emitting element may include, for example, an LED, an IR LED, and a xenon lamp.

The display 201 may be visible to the outside of the electronic device 200 through, for example, a substantial portion of the front plate 202. In some embodiments, the edges of the display 201 may be substantially the same as the shape of the outer periphery (e.g., a curved surface) of the front plate 202 adjacent thereto. In another embodiment (not illustrated), the distance between the outer periphery of the display 201 and the outer periphery of the front plate 202 may be substantially constant in order to enlarge the exposed area of the display 201. In another embodiment (not illustrated), a recess or an opening may be provided in a portion of a screen display region of the display 201, and other electronic components aligned with the recess or the opening, such as the camera module 205, a proximity sensor (not illustrated), or an illuminance sensor (not illustrated), may be included.

In another embodiment (not illustrated), the rear surface of the screen display region of the display 201 may include at least one of the camera modules 212, 213, 214, and 215, a fingerprint sensor, and a flash (e.g., 206). In another embodiment (not illustrated), the display 201 may be coupled to or disposed adjacent to a touch-sensitive circuit, a pressure sensor capable of measuring a touch intensity (pressure), and/or a digitizer configured to detect an electromagnetic field-type stylus pen.

The audio module 203 may include a microphone hole and a speaker hole. The microphone hole may include a microphone disposed therein so as to acquire external sound. In some embodiments, multiple microphones may be disposed so as to detect the direction of sound. In some embodiments, the speaker hole and the microphone hole may be implemented as a single hole 203, or a speaker (e.g., a piezo speaker) may be included without a speaker hole. The speaker hole may include an external speaker hole and a call receiver hole.

By including a sensor module (not illustrated), the electronic device 200 may generate an electrical signal or data value corresponding to an internal operating state or an external environmental condition. The sensor module may further include, for example, a proximity sensor disposed on the first surface 210A of the housing 210, a fingerprint sensor incorporated in or disposed adjacent to the display 201, and/or a biometric sensor (e.g., an HRM sensor) disposed on the second surface 210B of the housing 210. The electronic device 200 may further include at least one of sensor modules (not illustrated), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, 213, 214, 215, and 206 may include a first camera device 205 disposed on the first surface 210A of the electronic device 200, second camera devices 212, 213, 214, and 215 disposed on the second surface 210B thereof, and/or a flash 206. The above-described camera modules 205, 212, 213, 214, and 215 may include one or more lenses, an image sensor, and/or an image signal processor. The flash 206 may include, for example, a light-emitting diode or a xenon lamp. In some embodiments, two or more lenses (e.g., an infrared camera lens, a wide-angle lens, and a telephoto lens) and image sensors may be disposed on one surface of the electronic device 200.

The key input devices 217 may be disposed on the side surface 210C of the housing 210. In another embodiment, the electronic device 200 may not include some or all of the above-mentioned key input devices 217, and a key input device 217, which is not included in the electronic device 100, may be implemented in another form, such as a soft key, on the display 201. In some embodiments, the key input devices may include a fingerprint sensor disposed on the second surface 210B of the housing 210.

The connector hole 208 may accommodate a connector configured to transmit and receive power and/or data to and from an external electronic device and a connector configured to transmit and receive an audio signal to and from an external electronic device. For example, the connector hole 208 may include a USB connector or an earphone jack. In an embodiment, the USB connector and the earphone jack may be implemented as a single hole (e.g., 208 in FIGS. 2A and 2B), and according to another embodiment (not illustrated), the electronic device 200 may transmit/receive power and/or data or transmit/or receive an audio signal to/from an external electronic device (e.g., the electronic devices 102 and 104 in FIG. 1) without a separate connector hole.

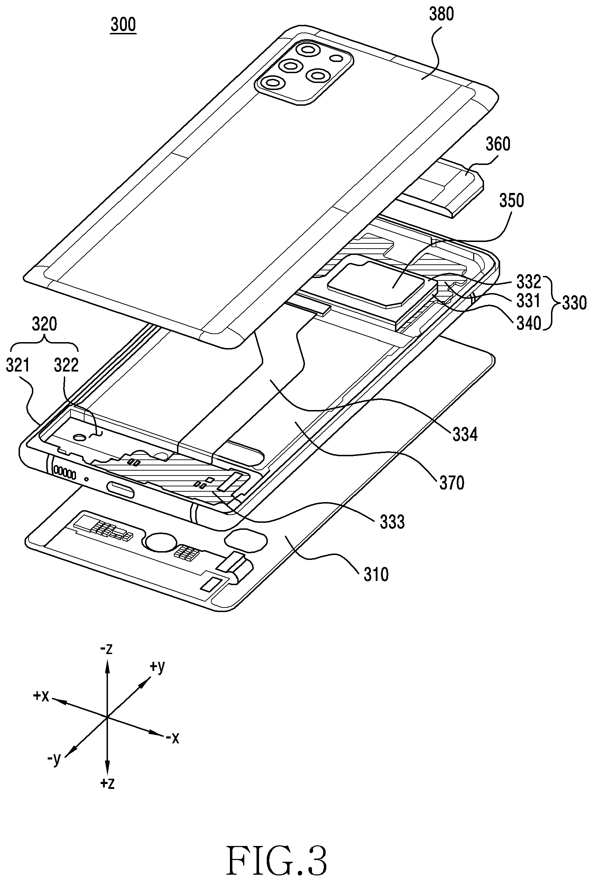

FIG. 3 is an exploded perspective view of an electronic device according to an embodiment.

Referring to FIG. 3, an electronic device 300 (e.g., the electronic device 200 in FIGS. 2A and 2B) according to an embodiment may include a front plate (not illustrated) (e.g., the front plate 202 in FIG. 2A), a display 310 (e.g., the display 201 in FIG. 2A), a side member 320 (e.g., the side member 218 in FIGS. 2A and 2B), a printed circuit board structure 330, a shield structure 350, a rear case 360, a battery 370, and/or a rear plate 380. At least one of the components of the electronic device 300 according to an embodiment may be the same as or similar to at least one of the components of the electronic device 101 of FIG. 1 and/or the electronic device 200 of FIGS. 2A and 2B, and redundant descriptions thereof will be omitted below.

According to an embodiment, the side member 320 is positioned between the display 310 and the back plate 380 and may include a metal frame structure 321 and/or a support member 322.

In an example, the metal frame structure 321 of the side member 320 may be formed of a conductive material (e.g., metal) to provide the side surface of the electronic device 300 (e.g., the side surface 210C in FIG. 2A). For example, the metal frame structure 321 may include at least one conductive portion and/or at least one non-conductive portion that insulates the at least one conductive portion. The at least one conductive portion of the metal frame structure 321 may operate as an antenna radiator for transmitting and/or receiving an RF signal of a predetermined frequency band.

In another example, the support member 322 of the side member 320 may be formed of a metal material and/or a non-metal (e.g., polymer) material to provide a space (or a "mounting space") that allows electronic components to be disposed in the electronic device 300. For example, the display 310 may be disposed on one surface of the support member 322 (e.g., the surface in the +z direction in FIG. 3), and the printed circuit board structure 330 may be disposed on the other surface of the support structure 412 (e.g., the surface in the -z direction in FIG. 3). According to an embodiment, the support member 322 may be connected to the metal frame structure 321 or may be configured integrally with the metal frame structure 321.

According to an embodiment, the printed circuit board structure 330 may be disposed in at least one region of the support member 322, and the above-described printed circuit board structure 330 may be a structure in which a plurality of printed circuit boards 331 and 332 are stacked. In an example, the printed circuit board structure 330 includes a first printed circuit board 331, a second printed circuit board 332, and an interposer 340. The above-described printed circuit board structure 330 may be a structure in which the interposer 340 and the second printed circuit board 332 are stacked in this order with reference to the first printed circuit board 331. For example, the first printed circuit board 331 may be disposed on the support member 322, and the second printed circuit board 332 may be spaced apart from the first printed circuit board 331 to be located in the -z direction with reference to the first printed circuit board 331. In another example, the interposer 340 may be interposed between the first printed circuit board 331 and the second printed circuit board 332 to support the second printed circuit board 332 located in the -z direction on the first printed circuit board 331. In an example, the interposer 340 may include at least one side wall and/or at least one conductive via penetrating at least one region of the side wall. In another example, the first printed circuit board 331 located at the bottom of the interposer 340 (e.g., the +z direction in FIG. 3) and the second printed circuit board 332 located at the top of the interposer 340 (e.g., the -z direction in FIG. 3) may be electrically connected to each other through at least one via in the interposer 340.

According to an embodiment, a plurality of electronic components may be disposed on the first printed circuit board 331 and/or the second printed circuit board 332 constituting the printed circuit board structure 330. For example, on the first printed circuit board 331 and/or the second printed circuit board 332, a processor (e.g., the processor 120 in FIG. 1), a memory (e.g., the memory 130 in FIG. 1), and/or an interface (e.g., the interface 177 in FIG. 1) may be disposed. The processor may include, for example, at least one of a central processing unit, an application processor, a graphics processing unit, an image signal processor, a sensor hub processor, or a communication processor. The memory may include, for example, a volatile memory or a non-volatile memory. The interface may include, for example, a high-definition multimedia interface (HDMI), a universal serial bus (USB) interface, an SD card interface, and/or an audio interface. The interface may electrically or physically connect, for example, the electronic device 200 to an external electronic device, and may include a USB connector, an SD card/an MMC connector, or an audio connector. In an example, the plurality of electronic components disposed on the first printed circuit board 331 and the plurality of electronic components disposed on the second printed circuit board 332 may be electrically and/or operatively connected to each other via the interposer 340.

According to an embodiment, the first printed circuit board 331 and/or the second printed circuit board 332 of the printed circuit board structure 330 may be electrically connected to a third printed circuit board 333 which is disposed to be spaced apart from the printed circuit board structure 330. For example, the first printed circuit board 331 and/or the second printed circuit board 332 of the printed circuit board structure 330 may be disposed in a region of the support member 322 (e.g., a region in the +y-direction in FIG. 3), and the third printed circuit board 333 may be disposed in another region of the support member 322 spaced apart from the first printed circuit board 331 and/or the second printed circuit board 332 (e.g., in the -y direction in FIG. 3). In an example, the first printed circuit board 331 and/or the second printed circuit board 332 may be electrically connected to the third printed circuit board 333 via an electrical connection member 334. In another example, the electrical connection member 334 may electrically interconnect the first printed circuit board 331 and/or the second printed circuit board 332 and the third printed circuit 333 across the battery 370 disposed on the support member 322. For example, the electrical connection member 334 may include at least one of a flexible printed circuit board (FPCB), a coaxial cable, and a board to board connector (a B to B connector), but is limited thereto.

According to an embodiment, the shield structure 350 (or a "shield can") may be formed of a conductive material (e.g., metal), and may be disposed in at least one region of the printed circuit board structure 330 to electromagnetically shield as plurality of electronic components disposed on the printed circuit board structure 330. In an example, the shield structure 350 is disposed on the second printed circuit board 332 of the printed circuit board structure 330, and may electromagnetically shield a plurality of electronic components disposed on the second printed circuit board 332. In another example (not illustrated), the shield structure 350 may include an extension (not illustrated) fixed to at least one region of the first printed circuit board 331 and/or the second printed circuit board 332 in order to secure the structural rigidity of the printed circuit board structure 330. A description of the extension of the shield structure 350 will be described later.

According to an embodiment, the rear case 360 may be disposed on the -z direction of the printed circuit board structure 330 to protect the first printed circuit board 331 and /or the second printed circuit board 332 and the plurality of electronic components disposed on the first printed circuit board 331 and/or the second printed circuit board 332 from an external force applied to the electronic device 300. In an example, the rear case 360 may be formed of a non-conductive material (e.g., plastic), but is not limited thereto. In an electronic device 300 according to another embodiment (not illustrated), the rear case 360 may be omitted.

According to an embodiment, the battery 370 may be disposed inside the electronic device 300 to supply power to at least one component of the electronic device 300. The battery 370 may include, for example, a non-rechargeable primary cell, a rechargeable secondary cell, or a fuel cell. In an example, the battery 370 may be disposed in a battery groove (not illustrated) provided in at least one region of the support member 322 to supply power to components of the electronic device 300. According to an embodiment, the battery 370 may be integrally disposed inside the electronic device 300, but is not limited thereto. A battery 370 according to another embodiment may be detachably disposed on the electronic device 300.

According to an embodiment, the rear plate 380 may define the rear surface of the electronic device 300 (e.g., the second surface 210B in FIG. 2B). The rear plate 380 may protect the internal components of the electronic device 300 from an external impact or inflow of foreign substances.

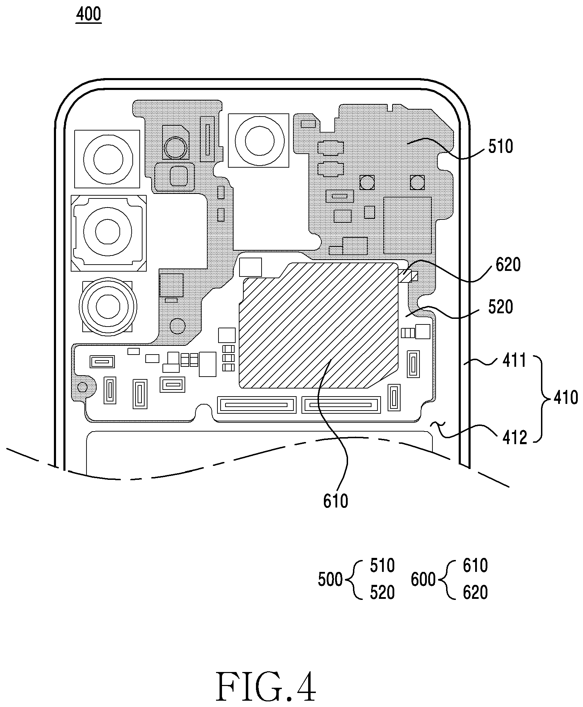

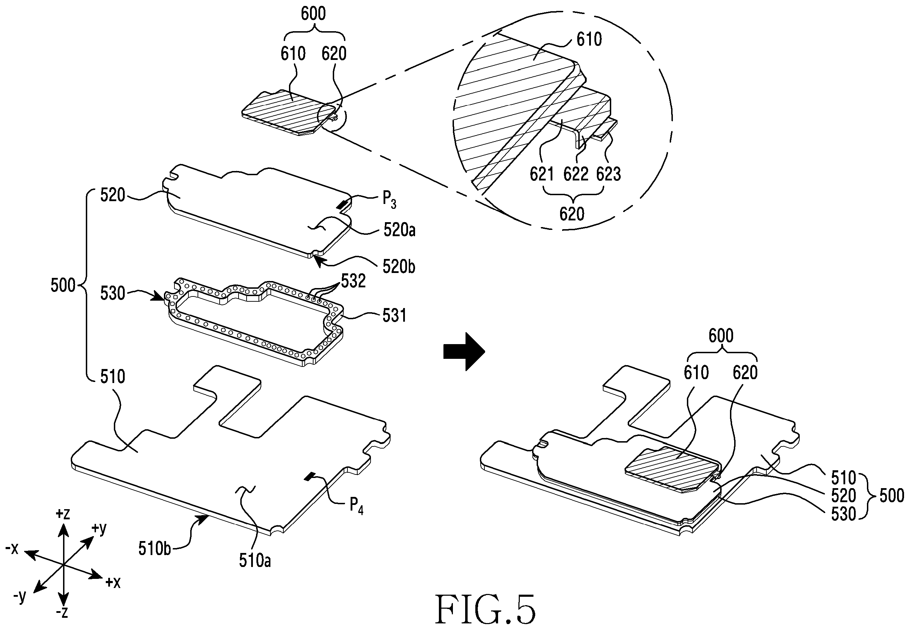

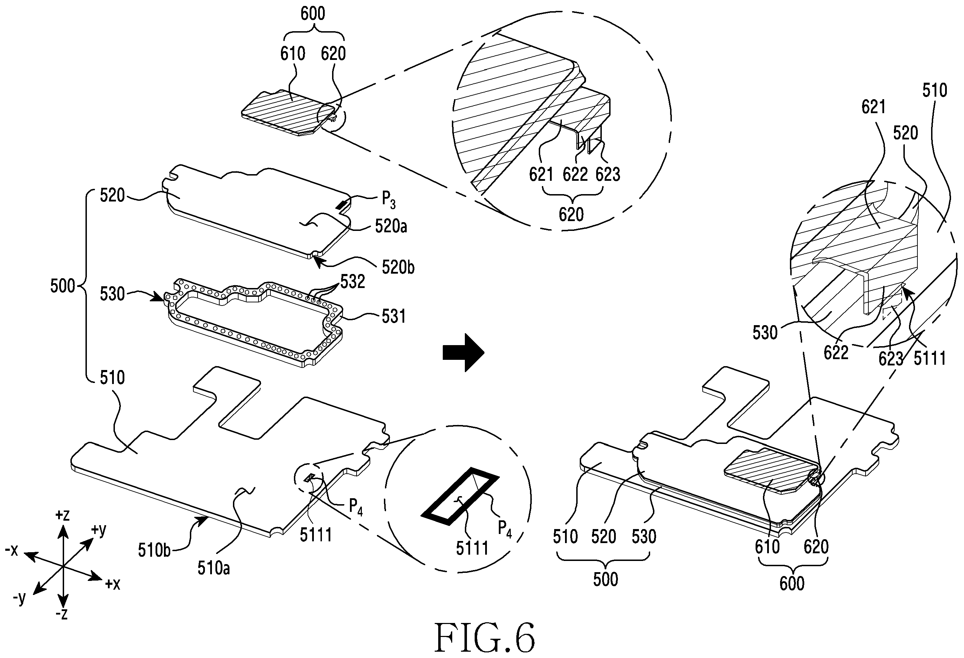

FIG. 4 is a view illustrating a side member of an electronic device according to an embodiment and a printed circuit board structure disposed on the side member, FIG. 5 is an exploded view illustrating a printed circuit board structure and a shield structure of an electronic device according to an embodiment, and FIG. 6 is an exploded view illustrating a printed circuit board structure and a shield structure of an electronic device according to another embodiment. FIG. 4 illustrates a partial region (e.g., a region in the +y direction in FIG. 4) of the side member 410 of the electronic device 400.

Referring to FIG. 4, FIG. 5, and/or FIG. 6, the electronic device 400 (the electronic device 300 in FIG. 3) according to an embodiment may include a side member 410 (e.g., the side member 320 in FIG. 3), a printed circuit board structure 500 (e.g., the printed circuit board structure 500 in FIG. 3), and/or a shield structure 600 (e.g., the shield structure 350 in FIG. 3). At least one of the components of the electronic device 400 according to an embodiment may be the same as or similar to at least one of the components of the electronic device 300 of FIG. 3, and redundant descriptions will be omitted below.

According to an embodiment, the side member 410 may include a metal frame structure 411 (e.g., the metal frame structure 321 in FIG. 3) and/or a support member 412 (e.g., the support member 322 in FIG. 3). In an example, the metal frame structure 411 of the side member 410 may define a side surface (e.g., the side surface 210C in FIG. 2A) of the electronic device 400. In another example, the support member 412 of the side member 410 may provide a space (or a "mounting space") in which components of the electronic device 400 (e.g., the printed circuit board structure 500) may be disposed.

According to an embodiment, the printed circuit board structure 500 may be disposed in at least one region of the support member 412, and the printed circuit board structure 500 includes a first printed circuit board 510 (e.g., the first printed circuit board 331 in FIG. 3), a second printed circuit board 520 (e.g., the second printed circuit board 332 in FIG. 3), and an interposer 530 (e.g., the interposer 340 in FIG. 3).

Referring to FIGS. 5 and 6, the printed circuit board structure 500 according to an embodiment may be a structure in which the interposer 530 and the second printed circuit board 520 are stacked in this order with reference to the first printed circuit board 510. In an example, the first printed circuit board 510 may include a first surface 510a facing a first direction (e.g., the +z direction in FIGS. 5 and 6) and a second surface 510b facing a second direction (e.g., the -z direction in FIGS. 5 and 6) opposite to the first direction. In another example, the second printed circuit board 520 is spaced apart from the first printed circuit board 510 and may include a third surface 520a facing the first direction and a fourth surface 520b facing a second direction opposite to the third surface 520a and facing the first surface 510a of the first printed circuit board 510. In an example, the interposer 530 may be interposed between the first surface 510a of the first printed circuit board 510 and the fourth surface 520b of the second printed circuit board 520, and the second printed circuit board 520 may be stacked at the top of the first printed circuit board 510 (e.g., in the +z direction in FIG. 5) via the above-described interposer 530. For example, a first solder pad (not illustrated) may be located in at least one region of the interposer 530 facing the first printed circuit board 510, and a (1-1)^{th} solder pad (not illustrated) may be located in at least one region of the first printed circuit board 510 facing the interposer 530. As another example, a second solder pad (not illustrated) may be located in at least one region of the interposer 530 facing the second printed circuit board 520, and a (2-1)^{th} solder pad (not illustrated) may be located in at least one region of the second printed circuit board 520 facing the interposer 530. In an example, as the first solder pad and the (1-1)^{th} solder pad are soldered to each other, the first printed circuit board 510 and the interposer 530 may be physically connected or fixed to each other. In another example, as the second solder pad and the (2-1)^{th} solder pad are soldered to each other, the second printed circuit board 520 and the interposer 530 may be physically connected or fixed to each other. Through the above-described connection relationship, the first printed circuit board 510 may be disposed at the bottom of the interposer 530 (e.g., in the -z direction in FIGS. 5 and 6), and the second printed circuit board 520 may be stacked at the top of the interposer 530 (e.g., in the +z direction in FIGS. 5 and 6).

According to an embodiment, the interposer 530 may include at least one side wall 531 and/or at least one via 532. In an example, the at least one side wall 531 may include at least one through hole (not illustrated) and extend along an edge of the second printed circuit board 520 disposed at the top of the interposer 530 (e.g., in the +z direction in FIG. 5). For example, the at least one side wall 531 may have a band-like closed curve shape corresponding to the edge shape of the second printed circuit board 520, but is not limited thereto. In an example, the at least one via 532 may be formed of a conductive material, and may be located in the at least one through hole to electrically interconnect the first printed circuit board 510 disposed at the bottom of the interposer 530 (e.g., in the -z direction in FIG. 5) and the second printed circuit board 520 disposed at the top of the interposer 530 (e.g., the +z direction in FIG. 5).

According to an embodiment, the shield structure 600 is disposed in at least one region of the third surface 520a of the second printed circuit board 520 to electromagnetically shield a plurality of electronic components disposed in the second printed circuit board 520. For example, the shield structure 600 may prevent noise generated from other components of the electronic device 400 from flowing into the plurality of electronic components disposed on the second printed circuit board 520. As another example, the shield structure 600 may block noise generated from the plurality of electronic components disposed on the second printed circuit board 520 from flowing out to the outside.

According to an embodiment, the shield structure 600 includes a body 610 and a first extension 620 extending from at least one region of the body 610, and the shield structure 600 increases the physical connection strength of the printed circuit board structure 500 by the first extension 620.

In an example, the body 610 of the shield structure 600 is disposed on at least one region of the third surface 520a of the second printed circuit board 520. In another example, the body 610 may be disposed in a shape that surrounds the plurality of electronic components disposed on the second printed circuit board 520 to electromagnetically shield the plurality of electronic components disposed on the second printed circuit board 520.

In an example, the first extension 620 of the shield structure 600 may be protrude from one region of the body 610 described above. The first extension 620 protrudes in a third direction (e.g., the +x direction in FIGS. 5 and 6) substantially perpendicular to the first direction with reference to the body 610. In another example (not illustrated), the first extension 620 may protrude in a fourth direction (e.g., the -y direction and/or the +y direction in FIGS. 5 and 6) substantially perpendicular to the first direction with reference to the body 610.

According to an embodiment, the first extension 620 of the shield structure 600 may extend up to at least one region (e.g., the first surface 510a) of the first printed circuit board 510 from the body 610. One region of the above-described first extension 620 is fixed to at least one region of the first printed circuit board 510 and/or the second printed circuit board 520 and reinforce the physical connection strength of the printed circuit board structure 500.

Referring to FIG. 5, the first extension 620 according to an embodiment may be configured in a surface-mounted device (SMD) form (or a "surface-mounted component form") and increase the physical connection strength of the first printed circuit board 510, the interposer 530, and/or the second printed circuit board 520. According to an embodiment, the first extension 620 includes a first portion 621 protruding from one region of the body 610, a second portion 622 connected to one end (e.g., the end in the +x direction in FIG. 5) of the first portion 621 substantially perpendicular to the first portion 621, and a third portion 623 connected to one end (e.g., the end in the -z direction in FIG. 5) of the second portion 622 substantially perpendicular to the second portion 622.

In an example, the first portion 621 of the first extension 620 protrudes from at least one region of the body 610 in a third direction (e.g., the +x direction in FIG. 5). In another example, the first portion 621 may be disposed adjacent to the third surface 520a of the second printed circuit board 520, and at least one region of the first portion 621 may be fixed to the third surface 520a of the second printed circuit board 520. For example, at least one region of the first portion 621 may be soldered to a third solder pad P₃ disposed on the third surface 520a of the second printed circuit board 520, but is not limited thereto. In the disclosure, "soldering" may refer to a process of applying heat to solder to fix some components (e.g., the first portion 621) to a specific location (e.g., the third surface 520a of the second printed circuit board 520), and may be used in an overlapping sense in the following.

In an example, the second portion 622 of the first extension 620 extends along a second direction (e.g., the -z direction in FIG. 5) perpendicular to the first portion 621 from one end (e.g., the end in the +x direction in FIG. 5) of the first portion 621. In another example, the second portion 622 may be disposed to be spaced apart from the second printed circuit board 520 and/or the interposer 530. Through the above-described arrangement structure, the second portion 622 may be disposed to face one surface of the second printed circuit board 520 and/or one surface of the interposer 530 facing the third direction (e.g., the +x direction in FIG. 5).

In an example, the third portion 623 of the first extension 620 may extend along the third direction (e.g., the +x direction in FIG. 5) substantially perpendicular to the second portion 622 from one end of the second portion 622 facing the first surface 510a of the first printed circuit board 510. In another example, the third portion 623 may be disposed adjacent to the first surface 510a of the first printed circuit board 510, and at least one region of the third portion 623 may be fixed to the first surface 510a of the first printed circuit board 510. For example, at least one region of the third portion 623 may be soldered to a fourth solder pad P₄ disposed on the first surface 510a of the first printed circuit board 510, but is not limited thereto.

According to an embodiment, the first extension 620 interconnects the first printed circuit board 510 and the second printed circuit board 520 via the first portion 621 fixed to the third surface 520a of the second printed circuit board 520, the third portion 623 fixed to the first surface 510a of the first printed circuit board 510, and the second portion 622 connecting the first portion 621 and the third portion 623. That is, the first extension 620 increases the physical connection strength between the first printed circuit board 510, the interposer 530, and/or the second printed circuit board 520 by providing a connection structure between the above-described first printed circuit board 510 and second printed circuit board 520.

Referring to FIG. 6, at least one region of the first extension 620 according to another embodiment may be configured in a pin shape (e.g., a dual in-line package (DIP) pin). The above-described first extension 620 may be inserted into at least one hole 5111 provided in at least one region of the first printed circuit board 510 to be fixed to at least one region of the first printed circuit board 510. According to an embodiment, the first extension 620 may include a first portion 621 protruding from one region of the body 610, a second portion 622 connected to one end (e.g., the end in the +x direction in FIG. 5) of the first portion 621 and substantially perpendicular to the first portion 621, and/or a third portion 623 connected to one end (e.g., the end in the -z direction in FIG. 5) of the second portion 622 and inserted into at least one region of the first printed circuit board 510.

In an example, the first portion 621 of the first extension 620 may protrude from at least one region of the body 610 in a third direction (e.g., the +x direction in FIG. 6). In another example, the first portion 621 may be disposed adjacent to the third surface 520a of the second printed circuit board 520, and at least one region of the first portion 621 may be fixed to the third surface 520a of the second printed circuit board 520. For example, at least one region of the first portion 621 may be soldered to a third solder pad P₃ disposed on the third surface 520a of the second printed circuit board 520, but is not limited thereto.

In an example, the second portion 622 of the first extension 620 may extend along a second direction (e.g., the -z direction in FIG. 6) perpendicular to the first portion 621 from one end (e.g., the end in the +x direction in FIG. 6) of the first portion 621. In another example, the second portion 622 may be disposed to be spaced apart from the second printed circuit board 520 and/or the interposer 530. Through the above-described arrangement structure, the second portion 622 may be disposed to face one surface of the second printed circuit board 520 and/or one surface of the interposer 530 facing the third direction (e.g., the +x direction in FIG. 6).

In an example, the third portion 623 of the first extension 620 may extend from one end of the second portion 622 facing the first surface 510a of the first printed circuit board 510. For example, the third portion 623 may extend in the second direction (e.g., the -z direction in FIG. 6) with reference to the above-mentioned one end of the second portion 622, but is not limited thereto. In another example, the third portion 623 may be inserted into at least one region of the first printed circuit board 510 and fixed to the at least one region of the first printed circuit board 510. In an example, at least one hole 5111 may be provided in the first surface 510a of the first printed circuit board 510, and the third portion 623 may be inserted into the at least one hole 5111 to be fixed to the first printed circuit board 510. For example, the third portion 623 may be fixed to the first printed circuit board 510 by being soldered to the fourth solder pad P₄ disposed around the at least one hole 5111 in the state of being inserted into the at least one hole 5111 of the first printed circuit board 510, but is not limited thereto. As another example, the at least one hole 5111 may be provided in a shape surrounding the outer circumferential surface of the third portion 623, and the fourth solder pad P₄ may be disposed in a shape surrounding the at least one hole 5111, but is not limited thereto.

According to an embodiment, the first extension 620 interconnects the first printed circuit board 510 and the second printed circuit board 520 via the first portion 621 fixed to the third surface 520a of the second printed circuit board 520, the third portion 623 fixedly inserted into the first printed circuit board 510, and/or the second portion 622 connecting the first portion 621 and the third portion 623. That is, the first extension 620 increases the physical connection strength between the first printed circuit board 510, the interposer 530, and/or the second printed circuit board 520 by providing a connection structure between the above-described first printed circuit board 510 and second printed circuit board 520.

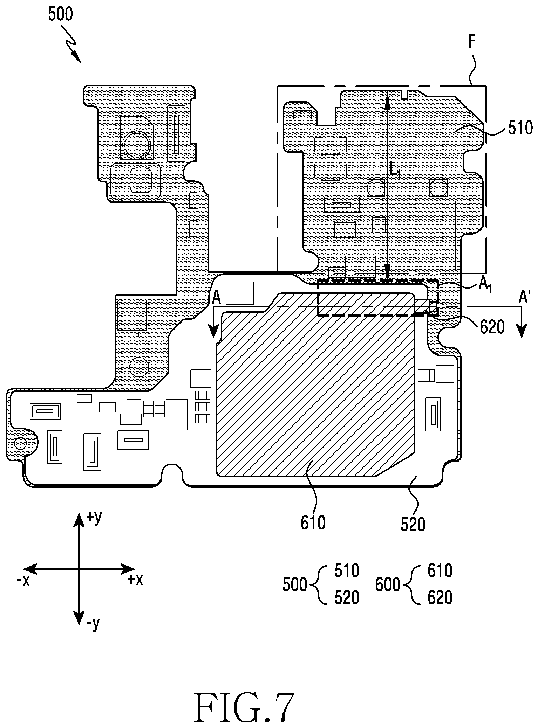

FIG. 7 is a front view illustrating a printed circuit board structure of an electronic device according to an embodiment. FIG. 7 illustrates a printed circuit board structure 500 and/or a shield structure 600 disposed inside an electronic device (e.g., the electronic device 400 in FIG. 4).

Referring to FIG. 7, an electronic device (e.g., the electronic device 400 in FIG. 4) according to an embodiment includes a printed circuit board structure 500 (e.g., the printed circuit board structure 500 in FIGS. 5 and 6) and a shield structure 600 (e.g., the shield structure 600 in FIGS. 5 and 6).

According to an embodiment, the printed circuit board structure 500 includes a first printed circuit board 510 (e.g., the first printed circuit board 510 in FIGS. 5 and 6) and a second printed circuit board 520 stacked on the first printed circuit board 510. In an example, the second printed circuit board 520 may be stacked on the first printed circuit board 510 via an interposer (not illustrated) disposed on at least one region of the first printed circuit board 510 (e.g., the interposer 530 in FIGS. 5 and 6). In another example, the first printed circuit board 510 and the second printed circuit board 520 may be electrically interconnected via an interposer interposed between the first printed circuit board 510 and the second printed circuit board 520. In an example, when viewed from the top of the printed circuit board structure 500 (e.g., in the +z direction in FIGS. 5 and 6), the area of the first printed circuit board 510 may be greater than the area of the second printed circuit board 520. In an example, the second printed circuit board 520 may be located inside a closed curve formed by the edges of the first printed circuit board 510. For example, the second printed circuit board 520 may be disposed such that the outer peripheral surface of the second printed circuit board 520 is included in the outer peripheral surface of the first printed circuit board 510 when viewed from the top of the printed circuit board structure 500 (e.g., in the +z direction in FIGS. 5 and 6). In another example (not illustrated), the second printed circuit board 520 may be disposed such that a partial region of the second printed circuit board 520 overlaps the first printed circuit board 510 while the remaining region does not overlap the first printed circuit board 510 when viewed from the top of the printed circuit board structure 500.

According to an embodiment, the shield structure 600 is located in at least one region of the second printed circuit board 520 of the printed circuit board structure 500 to shield a plurality of electronic components disposed in the at least one region of the second printed circuit board 520 (e.g., the third surface 520a in FIGS. 5 and 6). In an example, the shield structure 600 includes a body 610 (e.g., the body 610 in FIG. 5 and/or FIG. 6) fixed to the second printed circuit board 520 and a first extension 620 (e.g., the first extension 620 in FIG. 5 and/or FIG. 6) extending from the body 610. The first extension 620 of the shield structure 600 is fixed to at least one region of the first printed circuit board 510 and at least one region of the second printed circuit board 520 to provide a connection structure between the first printed circuit board 510 and the second printed circuit board 520. In the electronic device according to an embodiment, it is possible to improve or reinforce the physical connection strength of the printed circuit board structure 500 by the first extension 620 of the shield structure 600 that extends from the body 610 and interconnects the first printed circuit board 510 and the second printed circuit board 520.

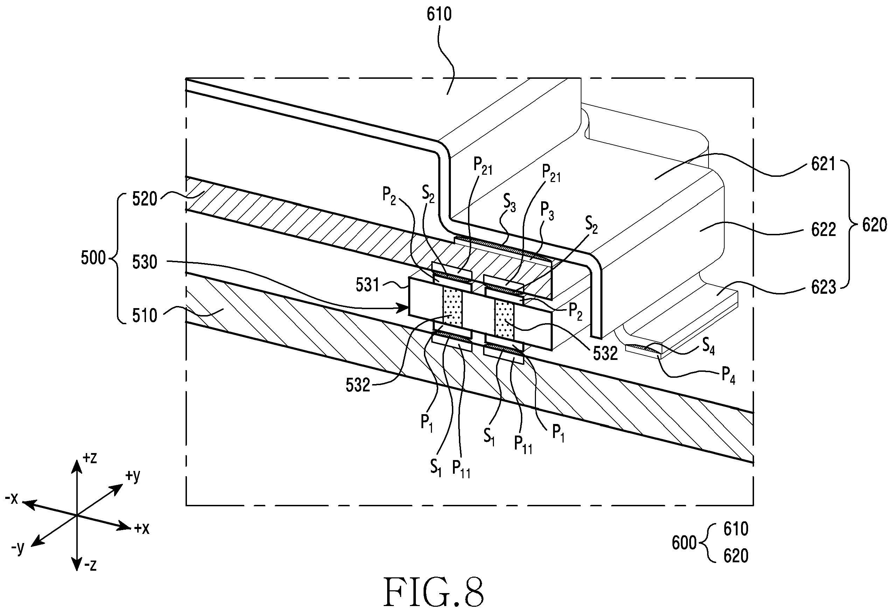

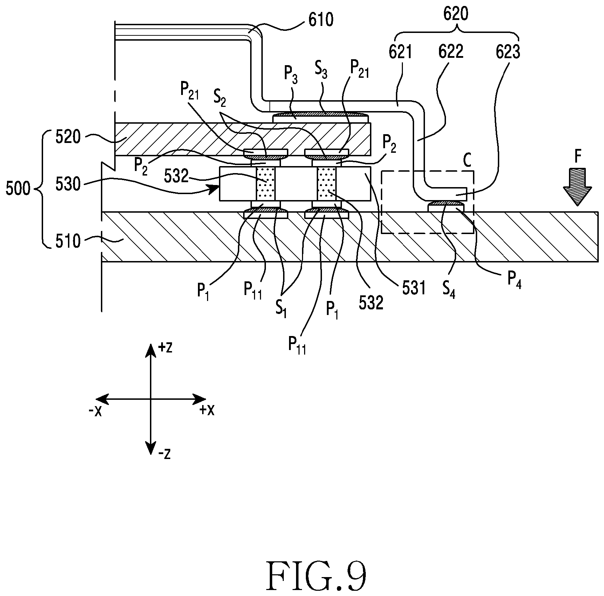

According to an embodiment, the first extension 620 of the shield structure 600 may be provided in a region in which the distance between an edge of the first printed circuit board 510 and an edge of the second printed circuit board 520 located inside the edge of the first printed circuit board 510 is equal to or greater than a predetermined distance (e.g., L₁ in FIG. 7). The predetermined distance may mean, for example, a distance in which a rigidity reinforcement effect may be obtained when a partial region of the first extension 620 is fixed or soldered to a region of the first printed circuit board 510. In an example, the first extension 620 of the shield structure 600 may be provided in a region in which the distance between an edge of the first printed circuit board 510 and an edge of the second printed circuit board 520 is the greatest (e.g., the region A₁ in FIG. 7), but is not limited thereto. When an external force is applied to an electronic device (e.g., the electronic device 300 of FIG. 3 or the electronic device 400 of FIG. 4), a relatively large amount of warpage may be generated in a region in which the distance between an edge of the first printed circuit board 510 and an edge of the second printed circuit board 520 is equal to or greater than the predetermined distance L₁ (e.g., the region F in FIG. 7) compared to other regions. By the warpage generated between the first printed circuit board 510 and the second printed circuit board 520, an impact (e.g., bending stress) may be transferred to the region in which the first printed circuit board 510, the interposer (e.g., the interposer 530 in FIGS. 5 and 6), and/or the second printed circuit board 520. By the impact transferred to the region in which the first printed circuit board 510, the interposer 530 and/or the second printed circuit board 520 are stacked, the soldering for connecting or fixing the first printed circuit board 510, the second printed circuit board 520, and/or the interposer may be fractured, or the connection between the first printed circuit board 510, the second printed circuit board 520, and/or the interposer 530 may be separated. According to an embodiment, the first extension 620 of the shield structure 600 may be located in the region in which the distance between an edge of the first printed circuit board 510 and an edge of the second printed circuit board 520 is equal to or greater than a predetermine distance L₁ (e.g., the region F in FIG. 7), and may provide a connection structure between the first printed circuit board 510 and the second printed circuit board 520. In the electronic device, the physical connection strength or rigidity between the first printed circuit board 510, the interposer 530, and/or the second printed circuit board 520 may be increased by the first extension 620 of the above-described shield structure 600, and as a result, damage to the printed circuit board structure 500 caused by the warpage of the first printed circuit board 510 and/or the second printed circuit board 520 may be reduced. Hereinafter, the structure of the first extension 620 will be described in detail with reference to FIGS. 8 and 9.

FIG. 8 is a cross-sectional perspective view illustrating the printed circuit board structure of FIG. 7 cut in A-A' direction, and FIG. 9 is a side view illustrating the printed circuit board structure of FIG. 8. FIG. 9 is a view of the printed circuit board structure 500 of FIG. 8 obtained when viewed in the -y direction (e.g., the -y direction in FIG. 8).

Although only an embodiment in which the first extension 620 of the shield structure 600 is configured in a surface-mount device (SMD) form is illustrated in FIG. 8 and/or FIG. 9, the structure of the first extension 620 is not limited to the illustrated embodiment. According to another embodiment (e.g., see FIG. 6), the first extension 620 of the shield structure 600 may be provided in the form of a pin (e.g., a dual in-line package (DIP) pin).

Referring to FIGS. 8 and 9, an electronic device (e.g., the electronic device 400 in FIG. 4) according to an embodiment includes a printed circuit board structure 500 (e.g., the printed circuit board structure in FIGS. 5 and 6) and a shield structure 600 (e.g., the shield structure 600 in FIGS. 5 and 6). The printed circuit board structure 500 and/or the shield structure 600 of FIGS. 8 and 9 may be substantially the same as or similar to the printed circuit board structure 500 and/or the shield structure 600 in FIG. 5 and/or FIG. 6, and redundant descriptions will be omitted below.

According to an embodiment, the printed circuit board structure 500 includes a first printed circuit board 510 (e.g., the first printed circuit board 510 in FIGS. 5 and 6), a second printed circuit board 520 (e.g., the second printed circuit board 520 in FIGS. 5 and 6), and an interposer 530 (e.g., the interposer 530 in FIGS. 5 and 6). In an example, the printed circuit board structure 500 may be a structure in which an interposer 530 and a second printed circuit board 520 are stacked in this order at the top (e.g., in the +z direction in FIGS. 8 and 9) with reference to the first printed circuit board 510. In another example, the interposer 530 may include at least one side wall 531 (e.g., the at least one side wall 531 in FIGS. 5 and 6) extending along at least one edge of the second printed circuit board 520 and/or at least one via 532 (e.g., the at least one via 532 in FIGS. 5 and 6) including a conductive material. In an example, at least one through hole (not illustrated) may be provided in the at least one side wall 531, and the at least one via 532 may be disposed in the at least one through hole to penetrate the at least one side wall 531. In another example, the first printed circuit board 510 disposed at the top of the interposer 530 (e.g., in the +z direction) and the second printed circuit 520 disposed at the bottom (e.g., in the -z direction) of the interposer 530 may be electrically interconnected via the at least one via 532.

According to an embodiment, the first printed circuit board 510 is fixed to at least one region of the bottom surface (e.g., the surface in the -z direction in FIGS. 8 and 9) of the interposer 530, and the second printed circuit board 520 may be fixed to at least one region of the top surface (e.g., the surface in the +z direction in FIGS. 8 and 9) of the interposer 530. For example, since a first solder pad P₁ disposed on the bottom surface of the interposer 530 and a (1-1)^{th} solder pad P₁₁ disposed on the top surface of the first printed circuit board 510 are soldered to each other, the first printed circuit board 510 may be fixed to at least one region of the bottom surface of the interposer 530. Accordingly, between the top surface (e.g., the first surface 510a in FIGS. 5 and 6) of the first printed circuit board 510 and the bottom surface of the interposer 530, a first solder region S₁ may be provided. In another example, since a second solder pad P₂ disposed on the top surface of the interposer 530 and a (2-1)^{th} solder pad P₂₁ disposed on the bottom surface of the second printed circuit board 520 are soldered to each other, the second printed circuit board 520 may be fixed to the top surface of the interposer 530. Accordingly, between the bottom surface (e.g., the fourth surface 520b in FIGS. 5 and 6) of the second printed circuit board 520 and the top surface of the interposer 530, a second solder region S₂ may be provided. The printed circuit board structure 500 according to an embodiment may increase the physical connection strength between the first printed circuit board 510, the interposer 530, and/or the second printed circuit board 520 by the first solder region S₁ provided between the first printed circuit board 510 and the interposer 530 and the second solder region S₂ provided between the second printed circuit board 520 and the interposer 530.

According to an embodiment, the shield structure 600 includes a body 610 disposed in at least one region of the second printed circuit board 520 and a first extension 620 extending from the body 610 and connecting the first printed circuit board 510 and the second printed circuit board 520. In an example, the body 610 of the shield structure 600 is disposed on the top surface (e.g., the third surface 520a in FIGS. 5 and 6) of the second printed circuit board 520, and may electromagnetically shield at least one electronic component (not illustrated) (e.g., the wireless communication module 192 in FIG. 1) disposed on the second printed circuit board 520. For example, the body 610 may block external noise introduced into the at least one electronic component disposed on the second printed circuit board 520. In an example, the first extension 620 of the shield structure 600 may protrude from at least one region of the body 610, and may serve to physically interconnect the first printed circuit board 510 and the second printed circuit board 520.

According to an embodiment, the first extension 620 includes a first portion 621, a second portion 622, and a third portion 623. The above-described first extension 620 interconnects the first printed circuit board 510 and the second printed circuit board 520 by the first portion 621, the second portion 622, and the third portion 623, whereby it is possible to improve or reinforce the physical connection strength of the printed circuit board structure 500.

In an example, the first portion 621 of the first extension 620 may be protrude from one region of the body 610. For example, the first portion 621 may extend in the +x direction with reference to the body 610. In another example, when viewed from the top of the shield structure 600 (e.g., in the +z direction in FIGS. 8 and 9), a partial region of the first portion 621 may overlap at least one region of the second printed circuit board 520 and the remaining region of the first portion 621 may overlap with at least one region of the first printed circuit board 510. In an example, at least one region of the first portion 621 may be fixed to at least one region of the second printed circuit board 520. For example, at least one region of the first portion 621 may be fixed to the second printed circuit board by being soldered to a third solder pad P₃ (e.g., the third solder pad P₃ in FIG. 5) disposed on the top surface (the surface facing the +z direction in FIGS. 8 and 9) of the second printed circuit board 520. As at least one region of the first portion 621 is soldered to at least one region of the second printed circuit board 520, a third solder region S₃ may be provided between the first portion 621 of the first extension 620 and the third solder pad P₃ of the second printed circuit board 520.

In an example, the second portion 622 of the first extension 620 may be connected to one end (e.g., the end in the +x direction in FIGS. 8 and 9) of the first portion 621, and may extend in a direction substantially perpendicular to the first portion 621 (e.g., the -z direction in FIGS. 8 and 9). For example, the second portion 622 may extend from one end of the first portion 621 by a length corresponding to the sum of the height of the second printed circuit board 520, the height of the interposer 530, and the height of the first solder pad P₁, the height of the second solder pad P₂, the first solder region S₁, and/or the second solder region S₂, but is not limited thereto. In another example, the second portion 622 may be disposed adjacent to the second printed circuit board 520 and/or the interposer 530, wherein at least one region of the second portion 622 may face one surface of the second printed circuit substrate 520 and/or one surface of the interposer 530 facing the +x direction.

In an example, the third portion 622 of the first extension 620 may be connected to one end (e.g., the end in the -z direction in FIGS. 8 and 9) of the second portion 622, and may extend in a direction substantially perpendicular to the second portion 622 (e.g., the +x direction in FIGS. 8 and 9). In another example, the third portion 622 may be disposed to be in contact with the top surface of the first printed circuit board 510 (e.g., the surface in the +z direction in FIGS. 8 and 9), and at least one region of the third portion 623 may be fixed to at least one region of the first printed circuit board 510. For example, at least one region of the third portion 623 may be fixed to the first printed circuit board 510 by being soldered to a fourth solder pad P₄ (e.g., the fourth solder pad P₄ in FIG. 5) disposed on the top surface of the first printed circuit board 510. As at least one region of the third portion 623 is soldered to the top surface of the first printed circuit board 510, a fourth solder region S₄ may be provided between the third portion 623 of the first extension 620 and the fourth solder pad P₄ of the first printed circuit board 510.

According to an embodiment, the shield structure 600 interconnects the first printed circuit board 510 and the second printed circuit board 520 via the first extension 620 including the first portion 621 fixed to the second printed circuit board 520, the third portion 623 fixed to the first printed circuit board 510, and the second portion 622 connecting the first portion 621 and the third portion 623. In an example, the shield structure 600 reinforces or increases the physical connection strength between the first printed circuit board 510, the interposer 530, and/or the second printed circuit board 520 by providing a connection structure between the first printed circuit board 510 and second printed circuit board 520 by the above-described first extension 620. That is, in the electronic device according to an embodiment, it is possible to increase the physical connection strength of the printed circuit board structure 500 by providing the third solder region S₃ between the first extension 620 and the second printed circuit board 520 and providing the fourth solder region S₄ between the first extension 620 and the first printed circuit board 510, in addition to providing the first solder region S₁ and/or the second solder region S₂ between the first printed circuit board 510, the second printed circuit board 520, and/or the interposer 530.

According to one embodiment, the shield structure 600 may disperse an impact (or "stress"), which is applied to the printed circuit board structure 500 by an external force, to the body 610 thereof via the first extension 620, whereby the shield structure 600 may reduce the fracture of or damage to the printed circuit board structure 500 due to the external force.

In an example, when the first extension 610 connecting the first printed circuit board 510 and the second printed circuit board 520 is not present, warpage may occur in the first printed circuit board 510 and/or the second printed circuit board 520 due to an external force (e.g., F in FIG. 9) applied to a region of the first printed circuit board 510. Due to the above-described warpage of the first printed circuit board 510 and/or the second printed circuit board 520, an impact (e.g., bending stress) may be transferred to the region (e.g., the region C in FIG. 9) in which the first printed circuit board 510, the interposer 530, and/or the second printed circuit board 520 are stacked. The impact transferred to the region (the region C) in which the first printed circuit board 510, the interposer 530, and/or the second printed circuit board 520 are stacked may cause damage or fracture of the first printed circuit board 510, the second printed circuit board 520, and/or the interposer 530.

In contrast, the shield structure 600 according to an embodiment may disperse, to the body 610, the impact transferred to the region (the region C) in which the first printed circuit board 510, the interposer 530, and/or the second printed circuit board 520 are stacked by including the first extension 610 fixed to one region (e.g., the regions S₁ and S₂) of the first printed circuit board 510 and/or the second printed circuit board 520 and extending from the body 610 thereof. In the electronic device according to an embodiment, it is possible to prevent or reduce damage or fracture of the printed circuit board structure 500 by dispersing an impact, which is applied to the first printed circuit board 510, the interposer 530, and/or the second printed circuit board 520, to the body 610 of the shield structure 600 via the first extension 620 of the shield structure 600.

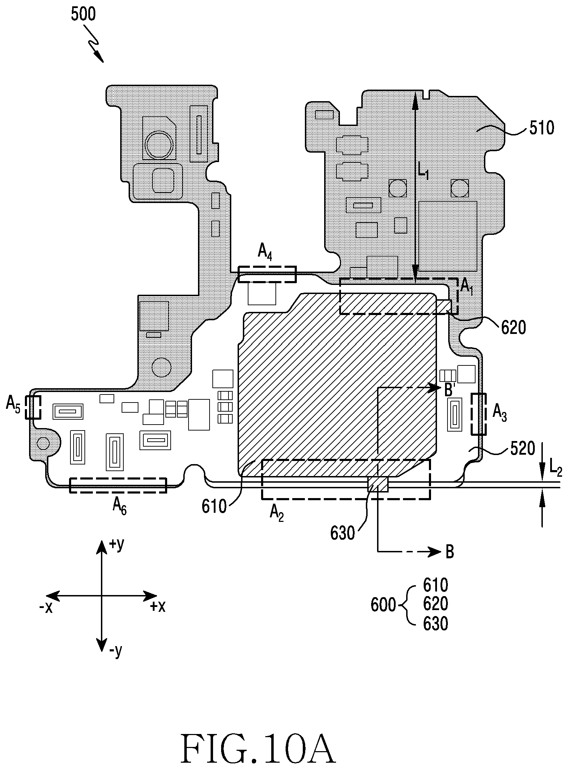

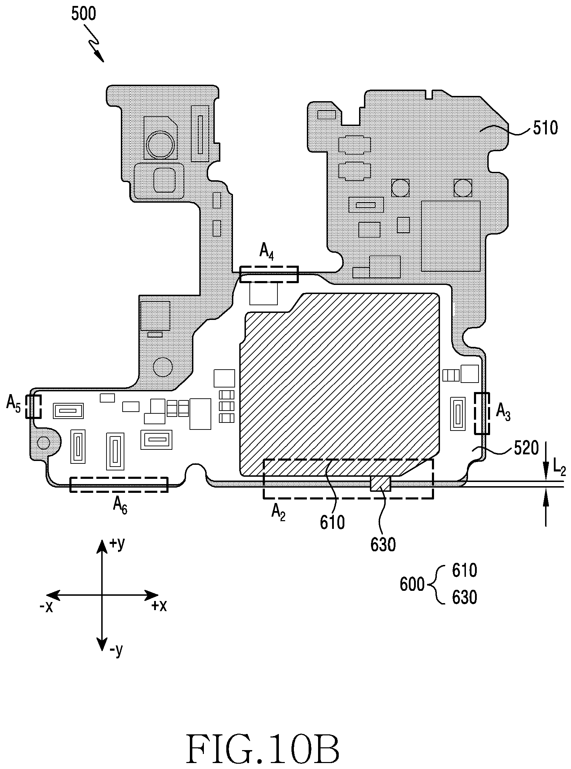

FIG. 10A is a front view illustrating a printed circuit board structure of an electronic device according to another embodiment, and FIG. 10B is a front view illustrating a printed circuit board structure of an electronic device according to still another embodiment not covered by the invention. FIG. 10A and/or FIG. 10B illustrate a printed circuit board structure 500 and/or a shield structure 600 disposed inside an electronic device (e.g., the electronic device 400 in FIG. 4).

Referring to FIGS. 10A and 10B, an electronic device (e.g., the electronic device 400 in FIG. 4) according to an embodiment includes a printed circuit board structure 500 (e.g., the printed circuit board structure 500 in FIGS. 4 and 5) and a shield structure 600 (e.g., the shield structure 600 in FIGS. 4 and 5) disposed in at least one region of the printed circuit board structure 500. The printed circuit board structure 500 and/or the shield structure 600 of FIG. 10A and/or FIG. 10 may be the same as or similar to the printed circuit board structure 500 and/or the shield structure 600 in FIG. 4 and/or FIG. 5, and redundant descriptions will be omitted below.

According to an embodiment, the printed circuit board structure 500 includes a first printed circuit board 510 (e.g., the first printed circuit board 510 in FIGS. 4 and 5), a second printed circuit board 520 (e.g., the second printed circuit board 520 in FIGS. 4 and 5) stacked on the first printed circuit board 510, and an interposer (not illustrated) (e.g., the interposer 530 in FIG. 5) interposed between the first printed circuit board 510 and the second printed circuit board 520 to electrically interconnect the first printed circuit board 510 and the second printed circuit board 520. In an example, when viewed from the top of the printed circuit board structure 500 (e.g., in the +z direction in FIG. 5), the area of the first printed circuit board 510 may be greater than the area of the second printed circuit board 520. In an example, the second printed circuit board 520 may be located inside a closed curve formed by the edges of the first printed circuit board 510. For example, the second printed circuit board 520 may be disposed such that the outer peripheral surface of the second printed circuit board 520 is included in the outer peripheral surface of the first printed circuit board 510 when viewed from the top of the printed circuit board structure 500 (e.g., in the +z direction in FIG. 5). In another example (not illustrated), the second printed circuit board 520 may be disposed such that a partial region of the second printed circuit board 520 overlaps the first printed circuit board 510 while the remaining region does not overlap the first printed circuit board 510 when viewed from the top of the printed circuit board structure 500.

According to an embodiment, the shield structure 600 is disposed in at least one region of the second printed circuit board 520 of the printed circuit board structure 500 and may electromagnetically shield at least one electronic component (e.g., the wireless communication module 192 in FIG. 1) disposed on the second printed circuit board 520. In an example, the shield structure 600 may include an extension region (e.g., the second extension 530 in FIGS. 10A and 10B) connecting the first printed circuit board 510 and the second printed circuit board 520, and the shield structure 600 may increase the physical connection strength of the printed circuit board structure 500 by the above-described extension region.

Referring to FIG. 10A, the shield structure 600 according to an embodiment includes a body 610 disposed on at least one region of the second printed circuit board 520 (e.g., the body 610 in FIGS. 7 and 8), a first extension 620 (e.g., the first extension 620 in FIGS. 7 and 8) extending from one region of the body 610, and a second extension extending from another region of the body 610. Referring to FIG. 10B, in the shield structure 600 according to another embodiment not covered by the present invention, the first extension 620 may be omitted, and thus the shield structure 600 may include only the body 610 and the second extension 630.

In an example, the body 610 of the shield structure 600 may be provided to surround at least one region of the second printed circuit board 520, and thus an internal space may be defined between the body 610 and the second printed circuit 520. At least one electronic component may be disposed in the internal space defined between the body 610 and/or the second printed circuit board 520, and the above-described body 610 may electromagnetically shield the at least one electronic component disposed in the internal space.

In an example, the first extension 620 of the shield structure 600 may extend from a region of the body 610, and the above-described first extension 620 may be fixed to at least one region of the first printed circuit board 510 and/or the second printed circuit board 520. In another example, the first extension 620 may be fixed to at least one region of the first printed circuit board 510 and/or the second printed circuit board 520, thereby providing a connection structure between the first printed circuit board 510 and the second printed circuit board 520. According to an embodiment, the first extension 620 may be configured in an SMD form (e.g., see FIG. 5) and may be fixed to at least one region of the first printed circuit board 510 and/or the second printed circuit board 520. However, the form of the first extension 620 is not limited to the above-described embodiment, and in another embodiment, the first extension 620 may be provided in a DIP form (e.g., see FIG. 6) and may be fixed to at least one region of the printed circuit board 510 and/or the second printed circuit board 520. Alternatively, the first extension 620 may be omitted according to an embodiment not covered by the invention (e.g., see FIG. 10B).

In an example, the second extension 630 of the shield structure 600 may extend from another region of the body 610, and the above-described second extension 630 may be fixed to at least one region of the first printed circuit board 510 and/or the second printed circuit board 520. For example, the second extension 630 may be disposed to be spaced apart from the first extension 620. In another example, the second extension 630 may be fixed to at least one region of the first printed circuit board 510 and/or the second printed circuit board 520, thereby providing a connection structure between the first printed circuit board 510 and the second printed circuit board 520. For example, the second extension 630 may be fixed to at least one region of the top surface (e.g., the third surface 520a in FIG. 5) of the second printed circuit board 520 and/or at least one region of a side surface (e.g., the surface in the -y direction in FIG. 10A) of the first printed circuit board 510, but is not limited thereto. In the electronic device according to an embodiment, it is possible to increase the physical connection strength of the printed circuit board structure 500 by the second extension 630 of the shield structure 600 connecting the first printed circuit board 510 and the second printed circuit board 520, which will be described later.

Referring to FIG. 10A, the first extension 620 of the shield structure 600 according to an embodiment may be provided in a region in which the distance between an edge of the first printed circuit board 510 and an edge of the second printed circuit board 520 located inside the edge of the first printed circuit board 510 is equal to or greater than a first distance (e.g., L₁ in FIG. 10A). The first distance L₁ may refer to, for example, a minimum distance for fixing or soldering a partial region (e.g., the third portion 623 of FIG. 5) first extension 620 to one surface (e.g., the first surface 510a in FIG. 5) of the first printed circuit board 510. In an example, the first extension 620 of the shield structure 600 may be provided in a region in which the distance between an edge of the first printed circuit board 510 and an edge of the second printed circuit board 520 is the greatest (e.g., the region A₁ in FIG. 10A), but is not limited thereto.

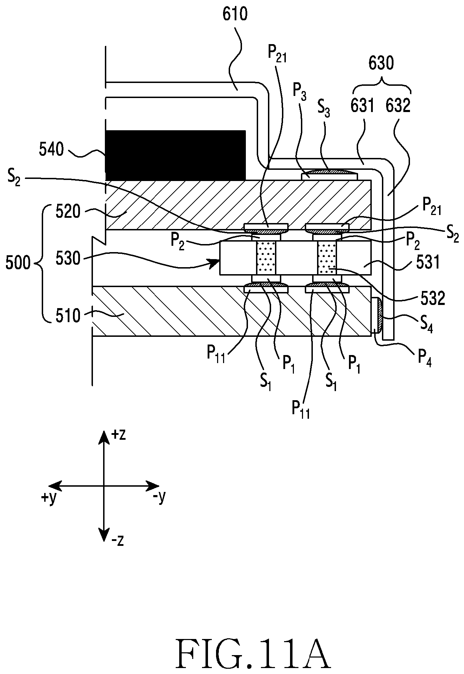

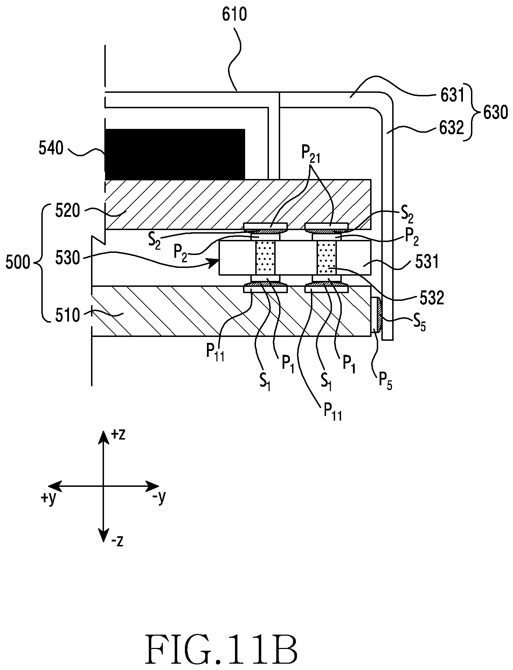

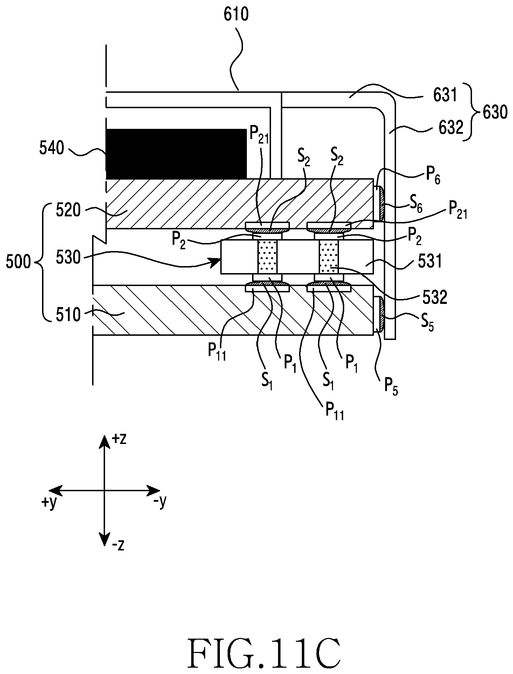

Referring to FIG. 10B, the second extension 630 of the shield structure 600 according to an embodiment not covered by the invention, may be provided in a region in which a second distance between an edge of the first printed circuit board 510 and an edge of the second printed circuit board 520 is equal to or smaller than a second distance L₂ (e.g., the region A₂, region A₃, region A₄, region A₅, and/or region A₆ in FIGS. 10A and 10B). The second distance L₂ may be a distance shorter than the first distance L₁. In an example, at least one region of the second extension 630 may be fixed to at least one region of a side surface (e.g., the surface in the -y direction in FIGS. 10A and 10B) of the first printed circuit board 510 unlike the first extension 620 fixed to the top surface (e.g., the first surface 510a in FIG. 5) of the first printed circuit board 510. Accordingly, the second extension 630 may be disposed in a region in which the distance between an edge of the first printed circuit board 510 and an edge of the second printed circuit board 520 is relatively short so as to serve interconnect the first printed circuit board 510 and the second printed circuit board 520. On FIG. 10A an embodiment and/or FIG. 10B, an embodiment not covered by the invention, in which the second extension 630 is provided in the region A₂ is illustrated, but the location where the second extension 630 is provided is not limited to the illustrated embodiment. According to another embodiment, the second extension 630 may be provided in at least one of the region A₃, the region A₄, the region A₅, or the region A₆ in which the distance between an edge of the first printed circuit board 510 and an edge of the second printed circuit board 520 is equal to or smaller than the second distance L₂. Hereinafter, the structure of the second extension 630 will be described with reference to FIG. 11A, FIG. 11B and/or FIG. 11C.

FIG. 11A is a cross-sectional view illustrating a printed circuit board structure according to an embodiment cut-in B-B' direction of FIG. 10A, FIG. 11B is a cross-sectional view illustrating a printed circuit board structure according to another embodiment cut in B-B' direction of FIG. 10A, and FIG. 11C is a cross-sectional view illustrating a printed circuit board structure according to still another embodiment cut in B-B' direction of FIG. 10A. Only the second extension 630 of FIG. 10A is illustrated in FIG. 11A, FIG. 11B, and/or FIG. 11C, the same structure may also be applied to the second extension 630 in FIG. 10B.

Referring to FIGS. 11A to 11C, an electronic device (e.g., the electronic device 400 in FIG. 4) according to an embodiment includes a printed circuit board structure 500 (e.g., the printed circuit board structure 500 in FIG. 10A) and a shield structure 600 (e.g., the shield structure 600 in FIG. 10A).

According to an embodiment, the printed circuit board structure 500 includes a first printed circuit board 510 (e.g., the first printed circuit board 510 in FIGS. 10A and 10B), a second printed circuit board 520 (e.g., the second printed circuit board 520 in FIGS. 10A and 10B), and an interposer 530 (e.g., the interposer 530 in FIGS. 5 and 6). In an example, the printed circuit board structure 500 may be a structure in which an interposer 530 and a second printed circuit board 520 are stacked in this order at the top (e.g., in the +z direction in FIG. 11A) with reference to the first printed circuit board 510. In another example, the interposer 530 may include at least one side wall 531 (e.g., the at least one side wall 531 in FIGS. 5 and 6) extending along at least one edge of the second printed circuit board 520 and/or at least one via 532 (e.g., the at least one via 532 in FIGS. 5 and 6) including a conductive material. In an example, at least one through hole (not illustrated) may be provided in the at least one side wall 531, and the at least one via 532 may be disposed in the at least one through hole to penetrate the at least one side wall 531. In another example, the first printed circuit board 510 disposed at the top of the interposer 530 (e.g., in the +z direction) and the second printed circuit 520 disposed at the bottom (e.g., in the -z direction) of the interposer 530 may be electrically interconnected via the at least one via 532.

According to an embodiment, the first printed circuit board 510 is fixed to at least one region of the bottom surface (e.g., the surface in the -z direction in FIGS. 11A to 11C) of the interposer 530, and the second printed circuit board 520 may be fixed to at least one region of the top surface (e.g., the surface in the +z direction in FIGS. 11A to 11C) of the interposer 530. For example, since a first solder pad P₁ disposed on the bottom surface of the interposer 530 and a (1-1)^{th} solder pad P₁₁ disposed on the top surface of the first printed circuit board 510 are soldered to each other, the first printed circuit board 510 may be fixed to at least one region of the bottom surface of the interposer 530. Accordingly, between the top surface (e.g., the first surface 510a in FIGS. 5 and 6) of the first printed circuit board 510 (or the (1-1)^{th} solder pad P₁₁) and the bottom surface of the interposer 530 (or the first solder pad P₁), a first solder region S₁ may be provided. In another example, since a second solder pad P₂ disposed on the top surface of the interposer 530 and a (2-1)^{th} solder pad P₂₁ disposed on the bottom surface of the second printed circuit board 520 are soldered to each other, the second printed circuit board 520 may be fixed to the top surface of the interposer 530. Accordingly, between the bottom surface (e.g., the fourth surface 520b in FIGS. 5 and 6) of the second printed circuit board 520 (or the (2-1)^{th} solder pad P₂₁) and the top surface of the interposer 530 (or the second solder pad P₂), a second solder region S₂ may be provided. The printed circuit board structure 500 according to an embodiment may increase the physical connection strength between the first printed circuit board 510, the interposer 530, and/or the second printed circuit board 520 by the first solder region S₁ provided between the first printed circuit board 510 and the interposer 530 and/or the second solder region S₂ provided between the second printed circuit board 520 and the interposer 530.

According to an embodiment, the shield structure 600 includes a body 610 disposed in at least one region of the second printed circuit board 520 and a second extension 630 extending from the body 610 and connecting the first printed circuit board 510 and the second printed circuit board 520. In an example, the body 610 of the shield structure 600 is disposed on the top surface (e.g., the third surface 520a in FIGS. 5 and 6) of the second printed circuit board 520, and may electromagnetically shield at least one electronic component 540 (e.g., the wireless communication module 192 in FIG. 1) disposed on the second printed circuit board 520. For example, the body 610 may block external noise introduced into the at least one electronic component 540 disposed on the second printed circuit board 520. In an example, the first extension 620 of the shield structure 600 may protrude from at least one region of the body 610, and may serve to physically interconnect the first printed circuit board 510 and the second printed circuit board 520.

According to an embodiment, the second extension 630 may include a fourth portion 631 and/or a fifth portion 632, and the above-described second extension 630 may interconnect the body 610 of the shield structure 600 and the first printed circuit board 510 by the fourth portion 631 and/or the fifth portion 632. In the electronic device according to an embodiment, it is possible to improve or reinforce the physical connection strength of the printed circuit board structure 500 by the above-described second extension 630.

Referring to FIG. 11A, the second extension 630 according to an embodiment may include a fourth portion 631 extending from one region of the body 610 and/or a fifth portion 632 connected to one end (e.g., the end in the -y direction in FIG. 11A) of the fourth portion 631 and extending in a direction substantially perpendicular to the fourth portion 631 (e.g., the -z direction in FIG. 11A).

In an example, the fourth portion 631 may be disposed adjacent to the top surface (e.g., the surface in the +z direction in FIG. 11A) of the second printed circuit board 520, and may be fixed to at least one region of the top surface of the second printed circuit board 520. For example, at least one region of the fourth portion 631 may be fixed to at least one region of the second printed circuit board 520 by being soldered to a third solder pad P₃ disposed in at least one region of the second printed circuit board 520. As the fourth portion 631 is soldered to the third solder pad P₃ of the second printed circuit board 520, a third solder region S₃ may be provided between the fourth portion 631 and the third solder pad P₃ of the second printed circuit board 520. In an example, the fifth portion 632 may be disposed to be spaced apart from the first printed circuit board 510, the second printed circuit board 520, and/or the interposer 530, and at least one region of the fifth portion 632 may be disposed to face the side surface of the first printed circuit board 510, the second printed circuit board 520, and/or the interposer 530 facing the -y direction. In another example, at least one region of the fifth portion 632 may be fixed to a side surface of the first printed circuit board 510. For example, at least one region of the fifth portion 632 may be fixed to at least one region of a side surface of the first printed circuit board 510 by being soldered to a fourth solder pad P₄ disposed on at least one region of the side surface the first printed circuit board 510. As the fifth portion 632 is soldered to the fourth solder pad P₄ on the side surface of the first printed circuit board 510, a fourth solder region S₄ may be provided between the fifth portion 632 and the side surface of the first printed circuit board 510.

According to an embodiment, the shield structure 600 may interconnect the first printed circuit board 510 and the second printed circuit board 520 by the second extension 630 including the fourth portion 631 fixed to the second printed circuit board 520 and/or the fifth portion 632 fixed to the side surface of the first printed circuit board 510. The shield structure 600 may reinforce or increase the physical connection strength between the first printed circuit board 510, the interposer 530, and/or the second printed circuit board 520 by providing a connection structure between the first printed circuit board 510 and the second printed circuit board 520 by the above-described first extension 630.

That is, in the electronic device according to an embodiment, it is possible to increase the physical connection strength of the printed circuit board structure 500 by providing the third solder region S₃ between the second extension 630 and the second printed circuit board 520 and providing the fourth solder region S₄ between the second extension 630 and the side surface of the first printed circuit board 510, in addition to providing the first solder region S₁ and/or the second solder region S₂ between the first printed circuit board 510, the second printed circuit board 520, and/or the interposer 530.

Referring to FIGS. 11B and 11C, the second extension 630 according to another embodiment may include a fourth portion 631 extending to one region of the body 610 and/or a fifth portion 632 connected to one end (e.g., the end in the -y direction in FIGS. 11B and 11C) of the fourth portion 631 and extending in a direction substantially perpendicular to the fourth portion 631 (e.g., the -z direction in FIGS. 11B and 11C).

In an example, the fourth portion 631 may be disposed to be spaced apart from the top surface (e.g., the surface in the +z direction in FIGS. 11B and 11C) of the second printed circuit board 520, and the fifth portion 632 may be connected to one end (e.g., the end in the -y direction in FIGS. 11B and 11C) of the fourth portion 631. For example, the fourth portion 631 may be disposed to be spaced apart from the top surface of the second printed circuit board 520 by the same length as the height of the body 610, but is not limited thereto. In an example, the fifth portion 632 may extend from one end of the fourth portion 631 in a direction perpendicular to the fourth portion 631, and the fifth portion 632 may be disposed to be spaced apart from the first printed circuit board 510, the second printed circuit board 520, and/or the interposer 530. At least one region of the fifth portion 632 may be disposed to face a side surface (e.g., the surface in the -y direction in FIGS. 11B and 11C) of the first printed circuit board 510, the second printed circuit board 520, and/or the interposer 530.

According to an embodiment (e.g., see FIG. 11B), at least one region of the fifth portion 632 may be fixed to at least one region of the side surface of the first printed circuit board 510. For example, at least one region of the fifth portion 632 may be fixed to at least one region of a side surface of the first printed circuit board 510 by being soldered to a fifth solder pad P₅ disposed on at least one region of the side surface the first printed circuit board 510. As the fifth portion 632 is soldered to the fifth solder pad P₅ disposed on the side surface of the first printed circuit board 510, a fifth solder region S₅ may be provided between the fifth portion 632 and the side surface of the first printed circuit board 510.

According to another embodiment (e.g., see FIG. 11C), at least one region of the fifth portion 632 may be fixed to at least one region of the side surface of the first printed circuit board 510 and/or the second printed circuit board 520. For example, at least one region of the fifth portion 632 may be fixed to at least one region of a side surface of the first printed circuit board 510 by being soldered to a fifth solder pad P₅ disposed on at least one region of the side surface the first printed circuit board 510. In another example, another region of the fifth portion 632 may be fixed to at least one region of a side surface of the second printed circuit board 520 by being soldered to a sixth solder pad P₆ disposed on at least one region of the side surface the second printed circuit board 520. As the fifth portion 632 is soldered to the fifth solder pad P₅ disposed on the side surface of the first printed circuit board 510, a fifth solder region S₅ may be provided between the fifth portion 632 and the side surface of the first printed circuit board 510. In addition, as the fifth portion 632 is soldered to the sixth solder pad P₆ disposed on the side surface of the second printed circuit board 510, a sixth solder region S₅ may be provided between the fifth portion 632 and the side surface of the second printed circuit board 520.

The shield structure 600 according to another embodiment may provide a connection structure between the body 610 of the shield structure 600 and the first printed circuit board 510 and/or the second printed circuit board 520 by the second extension 630 including the fifth portion 632 fixed to a side surface of the first printed circuit board 510 and/or a side surface of the second printed circuit board 520 and/or the fourth portion 631 connecting the fifth portion 632 and the body 610.

That is, it is possible to increase the physical connection strength of the printed circuit board structure 500 by the second extension 630 which provides a connection structure between the body 610 of the shield structure 600 and the first printed circuit board 510 and/or the second printed circuit board 520. In another example, in the electronic device, it is possible to disperse an impact (or "stress"), which is applied to the printed circuit board structure 500, to the body 610 of the shield structure 600 via the second extension 630, whereby it is possible to reduce damage to the printed circuit board structure 500.

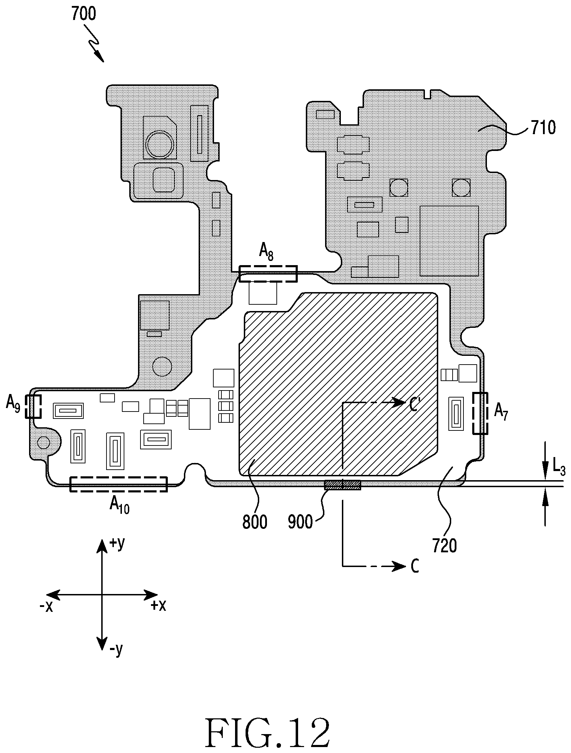

FIG. 12 is a front view illustrating a printed circuit board structure and a support structure of an electronic device according to an embodiment. FIG. 12 illustrates a printed circuit board structure 700, a shield structure 800, and/or a support structure 900 disposed inside an electronic device (e.g., the electronic device 400 in FIG. 4).

Referring to FIG. 12, an electronic device (e.g., the electronic device 300 in FIG. 3) according to an embodiment includes a printed circuit board structure 700 (e.g., the printed circuit board structure 500 in FIGS. 4 and 5), a shield structure 800 (the shield structure 600 in FIGS. 4 and 5) disposed in at least one region of the printed circuit board structure 500, and a support structure 900 disposed in another region of the printed circuit board structure 500. At least one of the components of the electronic device according to an embodiment may be the same as or similar to at least one of the components of the electronic device 400 of FIG. 4, and redundant descriptions will be omitted below.

According to an embodiment, the printed circuit board structure 700 includes a first printed circuit board 710 (e.g., the first printed circuit board 510 in FIGS. 4 and 5), a second printed circuit board 720 (e.g., the second printed circuit board 520 in FIGS. 4 and 5) stacked on the first printed circuit board 710, and/or an interposer (not illustrated) (e.g., the interposer 530 in FIG. 5) interposed between the first printed circuit board 710 and the second printed circuit board 720 to electrically interconnect the first printed circuit board 710 and the second printed circuit board 720. In one example, the first printed circuit board 710 may have an area larger than an area of the second printed circuit board 720. In an example, the second printed circuit board 720 may be located inside a closed curve formed by the edges of the first printed circuit board 710. For example, the second printed circuit board 720 may be disposed such that the outer peripheral surface of the second printed circuit board 720 is included in the outer peripheral surface of the first printed circuit board 710 when viewed from the top of the printed circuit board structure 700 (e.g., in the +z direction in FIG. 5). In another example (not illustrated), the second printed circuit board 720 may be disposed such that a partial region of the second printed circuit board 720 overlaps the first printed circuit board 710 while the remaining does not overlap the first printed circuit board 710 when viewed from the top of the printed circuit board structure 700.

According to an embodiment, the shield structure 800 is disposed in at least one region of the second printed circuit board 720 of the printed circuit board structure 700. For example, the shield structure 800 is provided to surround at least one region of the second printed circuit board 720, so that an internal space may be defined between the shield structure 800 and the second printed circuit board 720. At least one electronic component (not illustrated) (e.g., the wireless communication module 192 in FIG. 1) is disposed in at least one region of the second printed circuit board 720 included in the above-described internal space. In an example, the shield structure 800 may electromagnetically shield at least one electronic component disposed on the second printed circuit board 720. For example, the shield structure 80 may block external noise introduced into the at least one electronic component disposed on the second printed circuit board 720.

According to an embodiment, the support structure 900 may be disposed in at least one region of the second printed circuit board 720 of the printed circuit board structure 700 so as to increase the physical connection strength of the printed circuit board structure 700. In an example, the support structure 900 may serve to interconnect the first printed circuit board 710 and the second printed circuit board 720 by being fixed to a side surface of the first printed circuit board 710 (e.g., the surface in the -y direction in FIG. 12) and/or at least one region of the top surface (e.g., the third surface 520a in FIGS. 4 and 5) of the second printed circuit board 720. However, the configuration of the support structure 900 will be described later.

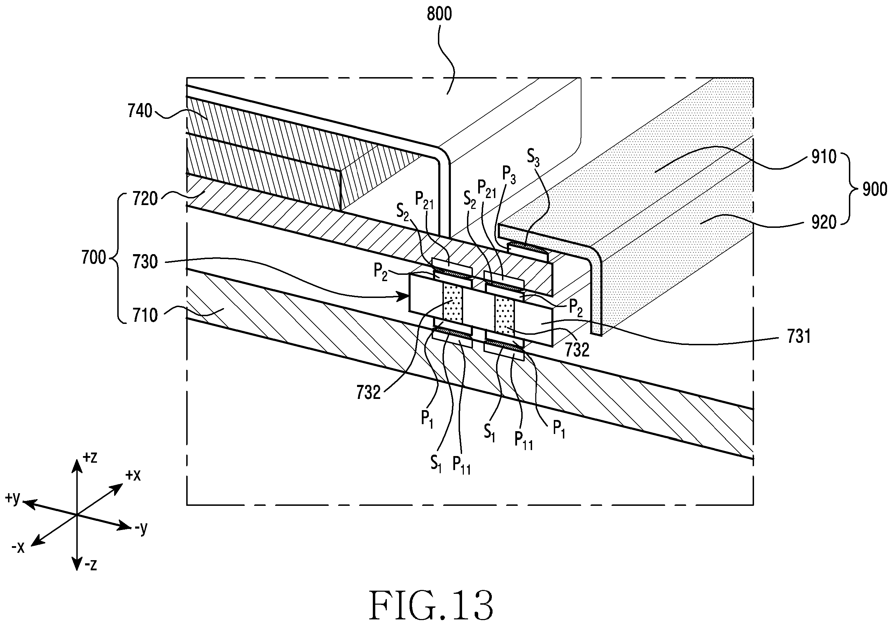

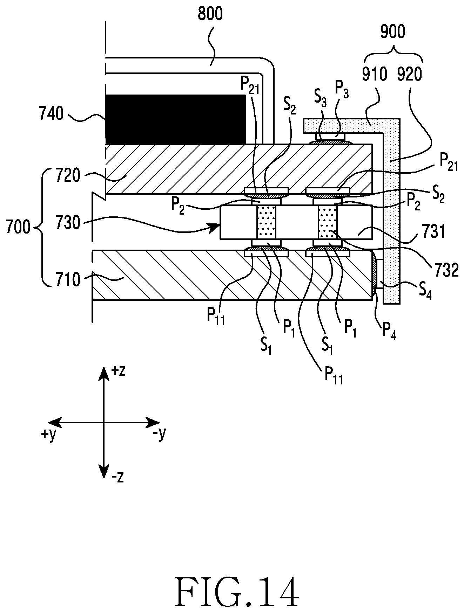

According to an embodiment, the support structure 900 may be disposed in a region in which the distance between an edge of the first printed circuit board 710 and an edge of the second printed circuit board 720 located inside the edge of the first printed circuit board 710 is equal to or smaller than a predetermined distance (e.g., L₃ in FIG. 12). For example, the support structure 900 may be disposed in a region in which an edge of the first printed circuit board 710 and an edge of the second printed circuit board 720 are adjacent to each other. In an example, as the support structure 900 is fixed to at least one region of a side surface of the first printed circuit board 710, a mounting space for the support structure 900 may not be secured on the first printed circuit board 710. Accordingly, the support structure 900 may be disposed in a region in which the distance between an edge of the first printed circuit board 710 and an edge of the second printed circuit board 720 is short. The region in which the support structure 900 may be disposed is not limited to the region illustrated in FIG. 12, and according to an embodiment, the support structure 900 may be provided in at least one of a region A₇, a region A₈, a region A₉, or a region A₁₀ in which the distance between an edge of the first printed circuit board 710 and an edge of the second printed circuit board 720 is equal to or smaller than a predetermined distance L₃. Hereinafter, the shape of the support structure 900 will be described with reference to FIG. 13 and/or FIG. 14.

FIG. 13 is a cross-sectional perspective view illustrating the printed circuit board structure and the support structure of FIG. 12 cut in C-C' direction, and FIG. 14 is a side view illustrating the printed circuit board structure and the supporting structure of FIG. 13. FIG. 14 is a view of the printed circuit board structure 700 of FIG. 13 obtained when viewed in the -x direction (e.g., the -x direction in FIG. 13).

Referring to FIGS. 13 and 14, an electronic device (e.g., the electronic device 400 in FIG. 4) according to an embodiment includes a printed circuit board structure 700 (e.g., the printed circuit board structure 700 in FIG. 12), a shield structure 800 (e.g., the shield structure 800 in FIG. 12), and a support structure 900 (e.g., the support structure 900 in FIG. 12). The printed circuit board structure 700, the shield structure 800, and/or the support structure 900 of the electronic device according to an embodiment may be the same as or similar to the printed circuit board structure 700, the shield structure 800, and/or the support structure 900 in FIG. 12, and redundant descriptions will be omitted below.

According to an embodiment, the printed circuit board structure 700 includes a first printed circuit board 710 (e.g., the first printed circuit board 710 in FIG. 12), a second printed circuit board 720 (e.g., the second printed circuit board 720 in FIG. 12), and an interposer 730 (e.g., the interposer 530 in FIGS. 5 and 6). In an example, the printed circuit board structure 700 may be a structure in which an interposer 730 and a second printed circuit board 720 are stacked in this order at the top (e.g., in the +z direction in FIGS. 12 and 13) with reference to the first printed circuit board 710. In another example, the interposer 730 may include at least one side wall 731 (e.g., the at least one side wall 531 in FIGS. 5 and 6) extending along at least one edge of the second printed circuit board 720 and/or at least one via 732 (e.g., the at least one via 532 in FIGS. 5 and 6) including a conductive material. In an example, at least one through hole (not illustrated) may be provided in the at least one side wall 731, and the at least one via 732 may be disposed in the at least one through hole to penetrate the at least one side wall 731. In another example, the first printed circuit board 710 disposed at the top of the interposer 730 (e.g., in the +z direction) and the second printed circuit 720 disposed at the bottom (e.g., in the -z direction) of the interposer 730 may be electrically interconnected via the at least one via 732.

According to an embodiment, the first printed circuit board 710 is fixed to at least one region of the bottom surface (e.g., the surface in the -z direction in FIGS. 13 and 14) of the interposer 730, and the second printed circuit board 720 may be fixed to at least one region of the top surface (e.g., the surface in the +z direction in FIGS. 13 and 14) of the interposer 730. For example, since a first solder pad P₁ disposed on the bottom surface of the interposer 730 and a (1-1)^{th} solder pad P₁₁ disposed on the top surface of the first printed circuit board 710 are soldered to each other, the first printed circuit board 710 may be fixed to at least one region of the bottom surface of the interposer 730. Accordingly, between the top surface (e.g., the first surface 710a in FIGS. 5 and 6) of the first printed circuit board 710 and the bottom surface of the interposer 730, a first solder region S₁ may be provided. In another example, since a second solder pad P₂ disposed on the top surface of the interposer 730 and a (2-1)^{th} solder pad P₂₁ disposed on the bottom surface of the second printed circuit board 720 are soldered to each other, the second printed circuit board 720 may be fixed to the top surface of the interposer 730. Accordingly, between the bottom surface (e.g., the fourth surface 520b in FIGS. 5 and 6) of the second printed circuit board 720 and the top surface of the interposer 730, a second solder region S₂ may be provided. The printed circuit board structure 700 according to an embodiment may increase the physical connection strength between the first printed circuit board 710, the interposer 730, and/or the second printed circuit board 720 by the first solder region S₁ provided between the first printed circuit board 710 and the interposer 730 and the second solder region S₂ provided between the second printed circuit board 720 and the interposer 730.

According to an embodiment, the shield structure 800 is disposed on the top surface (e.g., the surface in the +z direction in FIGS. 13 and 14) of the second printed circuit board 720, and may electromagnetically shield at least one electronic component 740 (e.g., the wireless communication module 192 in FIG. 1) disposed on the second printed circuit board 720. In an example, the shield structure 800 is provided to surround the at least one electronic component 740 to block shield external noise introduced into the at least one electronic component 740.

According to an embodiment, the support structure 900 may be disposed on at least one region of the top surface of the second printed circuit board 720 to be spaced apart from the shield structure 800, and the above-described support structure 900 may serve to reinforce the physical connection strength of the printed circuit board structure 700. In an example, the support structure 900 may be fixed to at least one region of the first printed circuit board 710 and the second printed circuit board 720, whereby the support structure 900 described above may serve to interconnect the first printed circuit board 710 and the second printed circuit board 720.

According to an embodiment, the support structure 900 may include a first portion 910 fixed to at least one region of the second printed circuit board 720 and/or a second portion which is substantially perpendicular to the first portion 910 and is fixed to at least one region of the first printed circuit board 710.

In an example, the first portion 910 of the support structure 900 may extend along a first direction parallel to the second printed circuit board 720 (e.g., the -y direction in FIGS. 13 and 14), and the above-described first portion 910 may be disposed adjacent to the top surface (e.g., the surface in the +z direction in FIGS. 13 and 14) of the second printed circuit board 720. In another example, the first portion 910 may be fixed to at least one region of the top surface of the second printed circuit board 720. For example, at least one region of the first portion 910 may be fixed to at least one region of the second printed circuit board 720 by being soldered to a third solder pad P₃ disposed on the second printed circuit board 720. In an example, as the first portion 910 of the support structure 900 is soldered to the third solder pad P₃ of the second printed circuit board 720, a third solder region S₃ may be provided between the first portion 910 and the second printed circuit board 720.

In an example, the second portion 920 of the support structure 900 may be connected to one end (e.g., the end in the -y direction in FIGS. 13 and 14) of the first portion 910, and may extend in a direction substantially perpendicular to the first portion 910 (e.g., the -z direction in FIGS. 13 and 14) with reference to one end of the first portion 910. In another example, the second portion 920 may be disposed to be spaced apart from the first printed circuit board 710, the second printed circuit board 720, and/or the interposer 730, and at least one region of the second portion 920 may be disposed to face the side surface of the first printed circuit board 710, the second printed circuit board 720, and/or the interposer 730 facing the -y direction.

In an example, at least one region of the second portion 920 may be fixed to a side surface (e.g., the surface facing the -y direction in FIGS. 13 and 14) of the first printed circuit board 710. For example, at least one region of the second portion 920 may be fixed to at least one region of a side surface of the first printed circuit board 710 by being soldered to a fourth solder pad P₄ disposed on at least one region of the side surface the first printed circuit board 710. In an example, as the second portion 920 of the support structure 900 is soldered to the fourth solder pad P₄ disposed on the side surface of the first printed circuit board 710, a fourth solder region S₄ may be provided between the second portion 920 and the side surface of the first printed circuit board 710.

In another example (not illustrated), at least one region of the second portion 920 may be fixed to not only the side surface of the second printed circuit board 720, but also the side surface of the first printed circuit board 710. For example, a region of the second portion 920 facing the side surface of the second printed circuit board 720 may be soldered to a solder pad (not illustrate) disposed on the side surface of the second printed circuit board 720. Accordingly, the second printed circuit board 720 may be fixed to the side surface of the second printed circuit board 720.

In the electronic device according to an embodiment, the support structure 900 including the first portion 910 fixed to at least one region (e.g., the top surface) of the second printed circuit board 720 and/or the second portion 920 fixed to at least one region (e.g., a side surface) of the first printed circuit board 710 may interconnect the first printed circuit board 710 and the second printed circuit board 720. That is, in the electronic device according to an embodiment, by the support structure 900, which interconnects the first printed circuit board 710 and the second printed circuit 720, it is possible to increase the physical connection strength of the first printed circuit board 710, the interposer 730, and/or the second printed circuit board 720. In addition, in the electronic device, by increasing the physical connection strength between the first printed circuit board 710, the interposer 730, and/or the second printed circuit board 720, it is possible to suppress the printed circuit board structure 700 from being damaged or fractured by an external force.

An electronic device (e.g., the electronic device 300 in FIG. 3 or the electronic device 400 in FIG. 4) according to an embodiment of the disclosure includes: a first printed circuit board (e.g., the first printed circuit board 510 in FIG. 5) including a first surface (e.g., the first surface 510a in FIG. 5) facing a first direction (e.g., the +z direction in FIG. 5) and a second surface (e.g., the second surface 510b in FIG. 5) facing a second direction (e.g., the -z direction in FIG. 5) opposite to the first direction; a second printed circuit board (e.g., the second circuit board 520 in FIG. 5) disposed to be spaced apart from the first printed circuit board and including a third surface (e.g., the third surface 520a in FIG. 5) facing the first direction and a fourth surface (e.g., the fourth surface 520b in FIG. 5) facing the first surface of the first printed circuit board; at least one electronic component disposed on the second printed circuit board; an interposer (e.g., the interposer 530 in FIG. 5) located between the first printed circuit board and the second printed circuit board and electrically connecting the first printed circuit board and the second printed circuit board; and a shield structure (e.g., the shield structure 600 in FIG. 5) located on at least one region of the third surface of the second printed circuit board and electromagnetically shielding the at least one electronic component, wherein the shield structure includes a body (e.g., the body 610 in FIGS. 8 and 9) located on the third surface of the second printed circuit board; and a first extension (e.g., the first extension 620 in FIGS. 8 and 9) protruding from the body and connecting the body and the first printed circuit board, and wherein the first extension may includes:
a first portion (e.g., the first portion 621 in FIGS. 8 and 9) protruding in a third direction (e.g., the +x direction in FIGS. 8 and 9) perpendicular to the first direction with reference to the body;
a second portion (e.g., the second portion 622 in FIGS. 8 and 9) extending along the second direction with reference to one end of the first portion and connecting the first portion and a third portion;
and the third portion (e.g., the third portion 623 in FIGS. 8 and 9) connected to one end of the second portion facing the first printed circuit board and wherein the first portion is fixed to at least one region of the third surface of the second printed circuit board and the third portion is fixed to at least one region of the first printed circuit board such that a physical connection strength between the first printed circuit board and the second printed circuit board increases.

In an example, the third portion may extend along the third direction with reference to the one end of the second portion.

In an example (e.g., see FIG. 5), the first portion may be soldered to at least one region of the third surface of the second printed circuit board, and the third portion may be soldered to at least one region of the first surface of the first printed circuit board.

In another example (e.g., see FIG. 6), the first printed circuit board may include at least one hole (e.g., the at least one hole 5111 in FIG. 6) provided in at least one region of the third surface, and the third portion may be fixedly inserted into the at least one hole of the first printed circuit board.

In another example, the first portion may be soldered to at least one region of the third surface of the second printed circuit board, and the third portion may be soldered into the at least one hole of the first printed circuit board.

In an example, the interposer may extend along an edge of the second printed circuit board.

In an example, the interposer may include at least one side wall (the at least one side wall 531 in FIGS. 8 and 9) extending along an edge of the second printed circuit board, at least one through hole provided in the at least one side wall, and at least one conductive via (e.g., the at least one via 532 in FIGS. 8 and 9) located in the at least one through hole.

In an example, the interposer may be soldered to at least one region of the first surface of the first printed circuit board and at least one region of the fourth surface of the second printed circuit board.

In an example, the first printed circuit board may have an area larger than an area of the second printed circuit board.

In an example, the outer peripheral surface of the second printed circuit board may be included in the outer peripheral surface of the first printed circuit board.

In an example, the first extension of the shield structure may be disposed in a region (e.g., A₁ in FIG. 7) in which the distance between an edge of the first printed circuit board and an edge of the second printed circuit board is equal to or greater than a predetermined distance (e.g., L₁ in FIG. 7) when viewed from above the second printed circuit board.

In an example, the shield structure may further include a second extension (e.g., the second extension 630 in FIGS. 10A and 10B) protruding from the body and connecting the body and the first printed circuit board.

In an example, the second extension portion may include a fourth portion (e.g., the fourth portion 631 in FIGS. 11A, 11B, and 11C) protruding in a fourth direction perpendicular to the first direction with reference to the body, and a fifth portion (e.g., the fifth portion 632 in FIGS. 11A, 11B, and 11C) extending along the second direction with reference to an end of the fourth portion and facing one surface of the first printed circuit board, one surface of the interposer, and/or one surface of the second printed circuit board facing the third direction.

In an example (e.g., see FIGS. 11A and 11B), the fifth portion may be fixed to at least one region of one surface of the first printed circuit board facing the fourth direction.

In an example (e.g., see FIG. 11A), the fourth portion may be fixed to at least one region of the third surface of the second printed circuit board.

In another example, the fifth portion (e.g., see FIG. 11C) may be fixed to at least one region of the one surfaces of the first printed circuit board and the second printed circuit board facing the third direction.

In an example, the second extension of the shield structure may be disposed in a region (e.g., A₂, A₃, A₄, or A₅ in FIG. 10A and 10B) in which the distance between an edge of the first printed circuit board and an edge of the second printed circuit board is equal to or smaller than a predetermined distance (e.g., L₂ in FIGS. 10A and 10B) when viewed from above the second printed circuit board.

An electronic device (e.g., the electronic device 300 in FIG. 3 or the electronic device 400 in FIG. 4) according to another example not covered by the invention may include: a first printed circuit board (e.g., the first printed circuit board 510 in FIG. 5) including a first surface (e.g., the first surface 510a in FIG. 5) facing a first direction (e.g., the +z direction in FIG. 5) and a second surface (e.g., the second surface 510b in FIG. 5) facing a second direction (e.g., the -z direction in FIG. 5) opposite to the first direction; a second printed circuit board (e.g., the second circuit board 520 in FIG. 5) disposed to be spaced apart from the first printed circuit board and including a third surface (e.g., the third surface 520a in FIG. 5) facing the first direction and a fourth surface (e.g., the fourth surface 520b in FIG. 5) facing the first surface of the first printed circuit board; at least one electronic component disposed on the first printed circuit board and the second printed circuit board; an interposer (e.g., the interposer 530 in FIG. 5) located between the first printed circuit board and the second printed circuit board and electrically connecting the first printed circuit board and the second printed circuit board; and a shield structure (e.g., the shield structure 600 in FIGS. 10A and 10B) located on at least one region of the third surface of the second printed circuit board and electromagnetically shielding the at least one electronic component, wherein the shield structure may include: a body (e.g., the body 610 in FIGS. 11A, 11B, and 11C) located on the third surface of the second printed circuit board; and a first extension (e.g., the second extension 630 in FIGS. 11A,11B, and 11C) protruding from the body and connecting the body and the first printed circuit board, and wherein the first extension may include: a first portion (e.g., the fourth portion 631 in FIGS. 11A, 11B, and 11C) extending along a third direction (e.g., the -y direction in FIGS. 11A, 11B, and 11C) perpendicular to the first direction with reference to the body; and a second portion (e.g., the fifth portion 632 in FIGS. 11A, 11B, and 11C) extending along the second direction with reference to one end of the first portion and facing one surfaces of the first printed circuit board, the interposer, and the second printed circuit board facing the third direction, and wherein the second portion may be fixed to at least one region of one surface of the first printed circuit board facing the third direction.

In an example, the first portion may be fixed to at least one region of the third surface of the second printed circuit board.

In an example, the second portion may be fixed to at least one region of the one surface of the second printed circuit board facing the third direction.

In the above-described specific embodiments of the disclosure, components included in the disclosure have been expressed in the singular or plural according to the presented specific embodiments. However, the singular or plural expressions are selected appropriately for the situation presented for convenience of description, and the disclosure is not limited to a singular constituent element or plural constituent elements. A constituent element expressed in the plural may be configured as a singular element, or a constituent element expressed in the singular may be configured as plural elements.

Meanwhile, in the detailed description of the disclosure, specific embodiments have been described, but various modifications are possible without departing from the scope of the disclosure. Therefore, the scope of the disclosure is defined by the appended claims.

## Claims

1. An electronic device (101; 200; 300) comprising:
a first printed circuit board (331; 510; 710) including a first surface facing a first direction and a second surface facing a second direction opposite to the first direction;
a second printed circuit board (332; 520; 720) disposed to be spaced apart from the first printed circuit board and including a third surface facing the first direction and a fourth surface facing the first surface of the first printed circuit board;
at least one electronic component disposed on the second printed circuit board (332; 520; 720);
an interposer (530) located between the first printed circuit board and the second printed circuit board and electrically connecting the first printed circuit board and the second printed circuit board; and
a shield structure (600; 800) located on at least one region of the third surface of the second printed circuit board (332; 520; 720) and electromagnetically shielding the at least one electronic component,
wherein the shield structure (600; 800) comprises:
a body (610) located on the third surface of the second printed circuit board; and
a first extension protruding from the body and connecting the body and the first printed circuit board (331; 510; 710), and
wherein the first extension comprises:
a first portion (621) protruding in a third direction perpendicular to the first direction with reference to the body;
a second portion (622) extending along the second direction with reference to one end of the first portion and connecting the first portion (621) and a third portion (623); and
the third portion (623) connected to one end of the second portion facing the first printed circuit board (331; 510; 710), and
wherein the first portion (621) is fixed to at least one region of the third surface of the second printed circuit board (332; 520; 720) and the third portion (623) is fixed to at least one region of the first surface of the first printed circuit board (331; 510; 710) such that a physical connection strength between the first printed circuit board and the second printed circuit board increases.

2. The electronic device (101; 200; 300) of claim 1, wherein the third portion (623) extends along the third direction with reference to the one end of the second portion (622).

3. The electronic device (101; 200; 300) of claim 2, wherein the first portion (621) is soldered to the at least one region of the third surface of the second printed circuit board (332; 520; 720), and
wherein the third portion (623) is soldered to the at least one region of the first surface of the first printed circuit board (331; 510; 710).

4. The electronic device (101; 200; 300) of claim 1, wherein the first printed circuit board (331; 510; 710) includes at least one hole (5111) provided in the at least one region of the third surface, and
wherein the third portion (623) is fixedly inserted into the at least one hole of the first printed circuit board (331; 510; 710).

5. The electronic device (101; 200; 300) of claim 4, wherein the first portion (621) is soldered to the at least one region of the third surface of the second printed circuit board (332; 520; 720), and
wherein the third portion is soldered into the at least one hole of the first printed circuit board.

6. The electronic device (101; 200; 300) of claim 1, wherein the interposer (530) extends along an edge of the second printed circuit board (332; 520; 720).

7. The electronic device (101; 200; 300) of claim 6, wherein the interposer (530) comprises:
at least one side wall (531) extending along an edge of the second printed circuit board (520);
at least one through hole provided in the at least one side wall (531); and
at least one conductive via (532) located within the at least one through hole.

8. The electronic device (101; 200; 300) of claim 6, wherein the interposer (530) is soldered to at least one region of the first surface of the first printed circuit board (510) and at least one region of the fourth surface of the second printed circuit board (520).

9. The electronic device (101; 200; 300) of claim 1, wherein the first printed circuit board (331; 510; 710) has an area larger than an area of the second printed circuit board (332; 520; 720).

10. The electronic device (101; 200; 300) of claim 9, wherein an outer peripheral surface of the second printed circuit board (332; 520; 720) is included in an outer peripheral surface of the first printed circuit board (331; 510; 710).

11. The electronic device (101; 200; 300) of claim 10, wherein the first extension portion of the shield structure (600; 800) is disposed in a region in which a distance between an edge of the first printed circuit board (331; 510; 710) and an edge of the second printed circuit board (332; 520; 720) is greater than or equal to a specific distance when viewed from above the second printed circuit board (332; 520; 720).

12. The electronic device (101; 200; 300) of claim 10, wherein the shield structure (600; 800) further includes a second extension (630) protruding from the body and connecting the body (610) and the first printed circuit board (331; 510; 710).

13. The electronic device (101; 200; 300) of claim 12, wherein the second extension (630) comprises:
a fourth portion (631) protruding in a fourth direction perpendicular to the first direction with reference to the body; and
a fifth portion (632) extending along the second direction with reference to one end of the fourth portion (631) and facing one surface of the first printed circuit board, one surface of the interposer, and/or one surface of the second printed circuit board facing the fourth direction.

14. The electronic device (101; 200; 300) of claim 13, wherein the fifth portion (632) is fixed to at least one region of one surface of the first printed circuit board facing the fourth direction.

15. The electronic device (101; 200; 300) of claim 14, wherein the fourth portion (631) is fixed to at least one region of the third surface of the second printed circuit board.

## Patentansprüche

1. Elektronische Vorrichtung (101; 200; 300) die Folgendes umfasst:
ein erste Leiterplatte (331; 510; 710), die eine in eine erste Richtung weisende erste Oberfläche und eine in eine zweite, der ersten Richtung gegenüber liegende Richtung weisende zweite Oberfläche aufweist;
eine zweite Leiterplatte (332; 520; 720), die so angeordnet ist, dass sie von der ersten Leiterplatte beabstandet ist, und die eine in die erste Richtung weisende dritte Oberfläche und eine zur ersten Oberfläche der ersten Leiterplatte weisende vierte Oberfläche aufweist;
zumindest eine auf der zweiten Leiterplatte (332; 520; 720) angeordnete elektronische Komponente;
ein zwischen der ersten Leiterplatte und der zweiten Leiterplatte angeordnetes Zwischenelement (530), das die erste Leiterplatte und die zweite Leiterplatte elektrisch verbindet; und
eine an zumindest einem Bereich der dritten Oberfläche der zweiten Leiterplatte (332; 520; 720) angeordnete Abschirmstruktur (600; 800), die die zumindest eine elektronische Komponente elektromagnetisch abschirmt,
wobei die Abschirmstruktur (600; 800) Folgendes umfasst:
einen auf der dritten Oberfläche der zweiten Leiterplatte befindlichen Körper (610); und
eine von dem Körper vorstehende und den Körper und die erste Leiterplatte (331; 510; 710) verbindende erste Verlängerung, und
wobei die erste Verlängerung Folgendes umfasst:
einen ersten Abschnitt (621), der unter Bezugnahme auf den Körper in einer senkrecht zu der ersten Richtung verlaufenden dritten Richtung vorsteht;
einen zweiten Abschnitt (622), der sich unter Bezugnahme auf ein Ende des ersten Abschnitts entlang der zweiten Richtung erstreckt und den ersten Abschnitt (621) und einen dritten Abschnitt (623) verbindet, und
wobei der dritte Abschnitt (623) mit einem zu der ersten Leiterplatte (331; 510; 710) weisenden Ende des zweiten Abschnitts verbunden ist, und
wobei der erste Abschnitt (621) an zumindest einem Bereich der dritten Oberfläche der zweiten Leiterplatte (332; 520; 720) befestigt ist und der dritte Abschnitt (623) an zumindest einem Bereich der ersten Oberfläche der ersten Leiterplatte (331; 510; 710) befestigt ist, so dass eine Stärke der physikalischen Verbindung zwischen der ersten Leiterplatte und der zweiten Leiterplatte zunimmt.

2. Elektronische Vorrichtung (101; 200; 300) nach Anspruch 1, wobei sich der dritte Abschnitt (623) unter Bezugnahme auf das eine Ende des zweiten Abschnitts (622) entlang der dritten Richtung erstreckt.

3. Elektronische Vorrichtung (101; 200; 300) nach Anspruch 2, wobei der erste Abschnitt (621) an den zumindest einen Bereich der dritten Oberfläche der zweiten Leiterplatte (332; 520; 720) gelötet ist, und
wobei der dritte Abschnitt (623) an den zumindest einen Bereich der ersten Oberfläche der ersten Leiterplatte (331; 510; 710) gelötet ist.

4. Elektronische Vorrichtung (101; 200; 300) nach Anspruch 1, wobei die erste Leiterplatte (331; 510; 710) zumindest ein Loch (5111) aufweist, das in dem zumindest einen Bereich der dritten Oberfläche vorgesehen ist, und
wobei der dritte Abschnitt (623) fest in das zumindest eine Loch der ersten Leiterplatte (331; 510; 710) eingeführt ist.

5. Elektronische Vorrichtung (101; 200; 300) nach Anspruch 4, wobei der erste Abschnitt (621) an den zumindest einen Bereich der dritten Oberfläche der zweiten Leiterplatte (332; 520; 720) gelötet ist, und
wobei der dritte Abschnitt in das zumindest eine Loch der ersten Leiterplatte eingelötet ist.

6. Elektronische Vorrichtung (101; 200; 300) nach Anspruch 1, wobei sich das Zwischenelement (530) entlang einer Kante der zweiten Leiterplatte (332; 520; 720) erstreckt.

7. Elektronische Vorrichtung (101; 200; 300) nach Anspruch 6, wobei das Zwischenelement (530) Folgendes umfasst:
zumindest eine sich entlang einer Kante der zweiten Leiterplatte (520) erstreckende Seitenwand (531);
zumindest ein in der zumindest einen Seitenwand (531) vorgesehenes Durchgangsloch; und
zumindest eine in dem zumindest einen Durchgangsloch befindliche leitende Durchkontaktierung (532).

8. Elektronische Vorrichtung (101; 200; 300) nach Anspruch 6, wobei das Zwischenelement (530) an zumindest einen Bereich der ersten Oberfläche der ersten Leiterplatte (510) und an zumindest einen Bereich der vierten Oberfläche der zweiten Leiterplatte (520) gelötet ist.

9. Elektronische Vorrichtung (101; 200; 300) nach Anspruch 1, wobei die erste Leiterplatte (331; 510; 710) eine Fläche aufweist, die größer als eine Fläche der zweiten Leiterplatte (332; 520; 720) ist.

10. Elektronische Vorrichtung (101; 200; 300) nach Anspruch 9, wobei eine äußere Umfangsoberfläche der zweiten Leiterplatte (332; 520; 720) in einer äußeren Umfangsoberfläche der ersten Leiterplatte (331; 510; 710) enthalten ist.

11. Elektronische Vorrichtung (101; 200; 300) nach Anspruch 10, wobei der erste Verlängerungsabschnitt der Abschirmstruktur (600; 800) in einem Bereich angeordnet ist, in dem ein Abstand zwischen einer Kante der ersten Leiterplatte (331; 510; 710) und einer Kante der zweiten Leiterplatte (332; 520; 720) größer oder gleich einem bestimmten Abstand ist, bei Betrachtung von oberhalb der zweiten Leiterplatte (332; 520; 720).

12. Elektronische Vorrichtung (101; 200; 300) nach Anspruch 10, wobei die Abschirmstruktur (600; 800) ferner eine zweite Verlängerung (630) aufweist, die von dem Körper vorsteht und den Körper (610) und die erste Leiterplatte (331; 510; 710) verbindet.

13. Elektronische Vorrichtung (101; 200; 300) nach Anspruch 12, wobei die zweite Verlängerung (630) Folgendes umfasst:
einen vierten Abschnitt (631), der unter Bezugnahme auf den Körper in einer senkrecht zur ersten Richtung verlaufenden vierten Richtung vorsteht; und
einen fünften Abschnitt (632), der sich unter Bezugnahme auf ein Ende des vierten Abschnitts (631) entlang der zweiten Richtung erstreckt und zu einer Oberfläche der ersten Leiterplatte, einer Oberfläche des Zwischenelements und/oder einer Oberfläche der zweiten Leiterplatte gerichtet ist, die in die vierte Richtung weist.

14. Elektronische Vorrichtung (101; 200; 300) nach Anspruch 13, wobei der fünfte Abschnitt (632) an zumindest einem Bereich einer Oberfläche der ersten Leiterplatte befestigt ist, die in die vierte Richtung weist.

15. Elektronische Vorrichtung (101; 200; 300) nach Anspruch 14, wobei der vierte Abschnitt (631) an zumindest einem Bereich der dritten Oberfläche der zweiten Leiterplatte befestigt ist.

## Revendications

1. Appareil électronique (101 ; 200 ; 300) comprenant :
une première carte de circuit imprimé (331 ; 510 ; 710) présentant une première surface tournée dans une première direction et une deuxième surface tournée dans une deuxième direction opposée à la première direction,
une deuxième carte de circuit imprimé (332 ; 520 ; 720) disposée en étant espacée de la première carte de circuit imprimé et présentant une troisième surface tournée dans la première direction et une quatrième surface tournée vers la première surface de la première carte de circuit imprimé,
au moins un composant électronique disposé sur la deuxième carte de circuit imprimé (332 ; 520 ; 720),
un interposeur (530) situé entre la première carte de circuit imprimé et la deuxième carte de circuit imprimé et reliant électriquement la première carte de circuit imprimé et la deuxième carte de circuit imprimé, et
une structure de blindage (600 ; 800) située sur au moins une région de la troisième surface de la deuxième carte de circuit imprimé (332 ; 520 ; 720) et assurant une protection électromagnétique de l'au moins un composant électronique ;
ladite structure de blindage (600 ; 800) comprenant :
un corps (610) situé sur la troisième surface de la deuxième carte de circuit imprimé, et
une première extension dépassant dudit corps et reliant ledit corps et la première carte de circuit imprimé (331 ; 510 ; 710) ; et
ladite première extension comprenant :
une première partie (621) faisant saillie dans une troisième direction perpendiculaire à la première direction par rapport au corps ;
une deuxième partie (622) s'étendant dans la deuxième direction par rapport à une extrémité de ladite première partie et reliant ladite première partie (621) et une troisième partie (623) ; et
ladite troisième partie (623), reliée à une extrémité de la deuxième partie qui est tournée vers la première carte de circuit imprimé (331 ; 510 ; 710) ; et
ladite première partie (621) étant fixée à au moins une région de la troisième surface de la deuxième carte de circuit imprimé (332 ; 520 ; 720) et ladite troisième partie (623) étant fixée à au moins une région de la première surface de la première carte de circuit imprimé (331 ; 510 ; 710) pour accroitre une force de liaison physique entre la première carte de circuit imprimé et la deuxième carte de circuit imprimé.

2. Appareil électronique (101 ; 200 ; 300) selon la revendication 1, dans lequel la troisième partie (623) s'étend dans la troisième direction par rapport à ladite extrémité de la deuxième partie (622).

3. Appareil électronique (101 ; 200 ; 300) selon la revendication 2, dans lequel la première partie (621) est soudée à l'au moins une région de la troisième surface de la deuxième carte de circuit imprimé (332 ; 520 ; 720), et
dans lequel la troisième partie (623) est soudée à l'au moins une région de la première surface de la première carte de circuit imprimé (331 ; 510 ; 710).

4. Appareil électronique (101 ; 200 ; 300) selon la revendication 1, dans lequel la première carte de circuit imprimé (331 ; 510 ; 710) présente au moins un trou (5111) ménagé dans l'au moins une région de la troisième surface, et
dans lequel la troisième partie (623) est insérée de manière fixe dans l'au moins un trou de la première carte de circuit imprimé (331 ; 510 ; 710).

5. Appareil électronique (101 ; 200 ; 300) selon la revendication 4, dans lequel la première partie (621) est soudée à l'au moins une région de la troisième surface de la deuxième carte de circuit imprimé (332 ; 520 ; 720), et
dans lequel la troisième partie est soudée dans l'au moins un trou de la première carte de circuit imprimé.

6. Appareil électronique (101 ; 200 ; 300) selon la revendication 1, dans lequel l'interposeur (530) s'étend le long d'un bord de la deuxième carte de circuit imprimé (332 ; 520 ; 720).

7. Appareil électronique (101 ; 200 ; 300) selon la revendication 6, dans lequel l'interposeur (530) comprend :
au moins une paroi latérale (531) s'étendant le long d'un bord de la deuxième carte de circuit imprimé (520),
au moins un trou traversant prévu dans l'au moins une paroi latérale (531), et
au moins un trou d'interconnexion (532) situé à l'intérieur de l'au moins un trou traversant.

8. Appareil électronique (101 ; 200 ; 300) selon la revendication 6, dans lequel l'interposeur (530) est soudé à au moins une région de la première surface de la première carte de circuit imprimé (510) et à au moins une région de la quatrième surface de la deuxième carte de circuit imprimé (520).

9. Appareil électronique (101 ; 200 ; 300) selon la revendication 1, dans lequel la première carte de circuit imprimé (331 ; 510 ; 710) est de plus grande superficie que la deuxième carte de circuit imprimé (332 ; 520 ; 720).

10. Appareil électronique (101 ; 200 ; 300) selon la revendication 9, dans lequel une surface périphérique extérieure de la deuxième carte de circuit imprimé (332 ; 520 ; 720) est incluse dans une surface périphérique extérieure de la première carte de circuit imprimé (331 ; 510 ; 710).

11. Appareil électronique (101 ; 200 ; 300) selon la revendication 10, dans lequel la première partie d'extension de la structure de blindage (600 ; 800) est disposée dans une région dans laquelle une distance entre un bord de la première carte de circuit imprimé (331 ; 510 ; 710) et un bord de la deuxième carte de circuit imprimé (332 ; 520 ; 720) est supérieure ou égale à une certaine distance, vu depuis le dessus de la deuxième carte de circuit imprimé (332 ; 520 ; 720).

12. Appareil électronique (101 ; 200 ; 300) selon la revendication 10, dans lequel la structure de blindage (600 ; 800) comprend en outre une deuxième extension (630) faisant saillie du corps et reliant le corps (610) et la première carte de circuit imprimé (331 ; 510 ; 710).

13. Appareil électronique (101 ; 200 ; 300) selon la revendication 12, dans lequel la deuxième extension (630) comprend :
une quatrième partie (631) faisant saillie dans une quatrième direction perpendiculaire à la première direction par rapport au corps, et
une cinquième partie (632) s'étendant dans la deuxième direction par rapport à une extrémité de la quatrième partie (631) et tournée vers une surface de la première carte de circuit imprimé, une surface de l'interposeur et/ou une surface de la deuxième carte de circuit imprimé tournée dans la quatrième direction.

14. Appareil électronique (101 ; 200 ; 300) selon la revendication 13, dans lequel la cinquième partie (632) est fixée à au moins une région d'une surface de la première carte de circuit imprimé tournée dans la quatrième direction.

15. Appareil électronique (101 ; 200 ; 300) selon la revendication 14, dans lequel la quatrième partie (631) est fixée à au moins une région de la troisième surface de la deuxième carte de circuit imprimé.
